# EUROPÄISCHE PATENTANMELDUNG

(11) **EP 4 324 686 A1**
(43) Veröffentlichungstag der Anmeldung: **21.02.2024**
(21) Anmeldenummer: 23186787.0
(22) Anmeldetag: 20.07.2023
(51) Int. Cl.: B60L 53/16, B60L 1/02, B60L 53/302, H01R 13/533

(54) **KONTAKTIERUNGSELEMENT FÜR EINE STECKVERBINDUNGSEINRICHTUNG SOWIE STECKVERBINDUNGSEINRICHTUNG**

(30) Priorität: 19.08.2022 DE 102022120990
(71) Anmelder: Lisa Dräxlmaier GmbH, 84137 Vilsbiburg (DE)
(72) Erfinder: Schmittat, Lutz, 84137 Vilsbiburg (DE); Heckelsmüller, Stephan, 85386 Eching (DE)

(57) **Zusammenfassung**

Die Erfindung betrifft ein Kontaktierungselement (1) für eine Steckverbindungseinrichtung (2) sowie die Steckverbindungseinrichtung (2), mittels derer eine elektrisch leitfähige Steckverbindung herstellbar ist. Das Kontaktierungselement (1) weist einen Kühlkörper (3), der eine mit einem elektrisch nichtleitenden Kühlmittel durchströmbare Kühlmittelkammer (8) begrenzt, aus einem elektrisch leitfähigen Material ausgebildet ist sowie einen Kühlmittelkammeranteil (15) und einen Kühlmittelkammerdeckel (16) aufweist, die miteinander verbunden sind. Eine Einströmöffnung (4) und eine Ausströmöffnung (5) durchdringen einen Kühlmittelkammerdeckel (16), münden in die Kühlmittelkammer (8) und sind dazu eingerichtet, außenseitig des Kühlkörpers (3) mit einem Zulaufkanal eines Kühlmittelkreislaufs fluidisch verbunden zu werden. Zudem ist ein erstes Verbindungselement (6) des Kontaktierungselements (1) dazu eingerichtet, mit einem korrespondierenden, zweiten Verbindungselement (31) der Steckverbindungseinrichtung (2) eine flächige elektrisch leitende und wärmeleitende Verbindungsvorrichtung (32) zwischen einer Kontaktierungsfläche (33) des Kühlkörpers (3) und einer korrespondierenden Kontaktierungsfläche (34) einer Stromschiene (35) zu bilden.

## Beschreibung

### Technisches Gebiet

Die vorliegende Erfindung betrifft ein Kontaktierungselement für eine Steckverbindungseinrichtung sowie eine Steckverbindungseinrichtung, die das Kontaktierungselement aufweist. Eine solche Steckverbindungseinrichtung findet sich insbesondere bei Kraftfahrzeugen, die eine als elektrische Sekundärbatterie ausgebildete Traktionsbatterie aufweisen, die dazu eingerichtet ist, einer elektrischen Antriebseinheit des Kraftfahrzeugs elektrische Traktionsenergie bereitzustellen. Bei dem Kraftfahrzeug handelt es sich also zum Beispiel um ein reinelektrisch antreibbares Kraftfahrzeug oder um ein Hybrid-Kraftfahrzeug. Die Steckverbindungseinrichtung ist insbesondere kraftfahrzeugseitig angeordnet und korrespondiert zum Bilden/Schließen eines Lade- und/oder Entladestromkreises (um die Batterie zu laden bzw. zu entladen) mechanisch und elektrisch mit einer Gegensteckverbindungseinrichtung einer Energiequelle, zum Beispiel einem infrastrukturellen Stromnetz.

### Stand der Technik

Heutzutage besteht der Bedarf, eine Traktionsbatterie eines ganz oder teilweise elektrisch antreibbaren Kraftfahrzeug besonders effizient und insbesondere schnell elektrisch zu laden. Durch die dabei entstehenden hohen Ladeleistungen erwärmen sich stromführenden Elemente, wie Kabel, Kontaktierungselemente (Pins) etc., wobei mit steigender Temperatur ein ohmscher Widerstand des entsprechenden stromführenden Elements steigt. Ferner erwärmen sich die Kontaktierungselemente an Übergangsstellen besonders stark, da dort ein besonders hoher ohmscher Übergangswiderstand vorliegt. Dies wird noch weiter verschärft, wenn die Kontaktierungselemente abgenutzt und/oder verschmutzt sind, da sie dann nicht mehr sauber mit zugehörigen Kontaktierungspartnern der Gegensteckverbindungseinrichtung in Berührung gebracht werden können. Jedoch steht ein hoher ohmscher Widerstand einem gewünscht hohen Maß an elektrischer Ladeleistung entgegen - ist der ohmsche Widerstand zu hoch, kommt es zu einer Überhitzung und die Ladeleistung muss aus Sicherheitsgründen reduziert werden, was in einer erhöhten Ladedauer resultiert. Insbesondere aufgrund von Packaging-Vorgaben bei der Entwicklung von Kraftfahrzeugen ist ein effizientes Kühlen der stromführenden Elemente nur unter Einsatz von besonders hohem Aufwand möglich. Zudem wird die Wärmeabfuhr aufgrund einer zumeist beengten Bauraumsituation zusätzlich erschwert.

### Beschreibung der Erfindung

Aufgabe der Erfindung ist es, eine besonders effiziente Kühlung zum Kühlen von stromführenden Elementen beim Laden einer Batterie, insbesondere einer Traktionsbatterie eines Kraftfahrzeugs, zu ermöglichen.

Diese Aufgabe wird durch die Gegenstände der unabhängigen Patentansprüche gelöst. Weitere mögliche Ausgestaltungen der Erfindung sind in den Unteransprüchen, der Beschreibung und den Figuren offenbart. Merkmale, Vorteile und mögliche Ausgestaltungen, die im Rahmen der Beschreibung für einen der Gegenstände der unabhängigen Ansprüche dargelegt sind, sind zumindest analog als Merkmale, Vorteile und mögliche Ausgestaltungen des jeweiligen Gegenstands der anderen unabhängigen Ansprüche sowie jeder möglichen Kombination der Gegenstände der unabhängigen Ansprüche, gegebenenfalls in Verbindung mit einem oder mehr der Unteransprüche, anzusehen.

Gemäß der Erfindung wird ein Kontaktierungselement mit einem Kühlkörper vorgeschlagen, das für eine Steckverbindungseinrichtung vorgesehen ist. Darüber hinaus wird eine das Kontaktierungselement aufweisende Steckverbindungseinrichtung für ein Kraftfahrzeug vorgeschlagen, mittels derer eine elektrisch leitfähige Steckverbindung zwischen einer elektrischen Energiequelle (etwa einer Ladeinfrastruktur) und einer elektrischen Batterie (etwa einer Traktionsbatterie eines Kraftfahrzeugs) herstellbar ist. Hierzu werden die Steckverbindungseinrichtung und eine korrespondierende Gegensteckverbindungseinrichtung elektrisch miteinander gekoppelt. Auf diese Weise wird zwischen der Batterie und der Energiequelle mittels der Steckverbindungseinrichtung bzw. mittels des Kontaktierungselements eine elektrisch leitfähige Steckverbindung ausgebildet.

Das Kontaktierungselement weist den Kühlkörper auf, der eine mit einem elektrisch isolierenden bzw. elektrisch nichtleitenden Kühlmittel durchströmbare Kühlmittelkammer begrenzt und aus einem elektrisch leitfähigen Material ausgebildet ist. Der Kühlkörper ist insbesondere aus einem metallischen Material, etwa einem Metall, einer Metalllegierung etc. ausgebildet. Beispielsweise kommen hierzu Kupfer oder Aluminium in Frage. Der Kühlkörper weist einen Kühlmittelkammeranteil und einen Kühlmittelkammerdeckel auf. Der Kühlmittelkammerdeckel und der Kühlmittelkammeranteil können aus gleichem Material oder aus unterschiedlichen Materialien ausgebildet sein, sind aber jedenfalls beide elektrisch leitfähig und elektrisch miteinander kontaktiert. Der Kühlmittelkammeranteil und der Kühlmittelkammerdeckel bilden miteinander den Kühlkörper zumindest teilweise und umschließen die Kühlmittelkammer (abgesehen von einer Einströmöffnung und einer Ausströmöffnung, die weiter unten noch genauer beschrieben werden). Der Kühlkörper, der die Kühlmittelkammer (abgesehen von der Einströmöffnung und der Ausströmöffnung) vollständig umschließt, kann als ein monolithisches Teil ausgeführt sein. Dies wird beispielsweise erreicht, wenn der Kühlmittelkammerdeckel und der Kühlmittelkammeranteil unter dem Herstellen des Kühlkörpers miteinander generativ/additiv hergestellt werden. Mit anderen Worten: Der Kühlmittelkammerdeckel und der Kühlmittelkammeranteil können in einem gemeinsamen generativen/additiven Herstellungsprozess hergestellt werden, wobei dadurch der Kühlkörper gebildet wird. Dabei können die Ein- und die Ausströmöffnung im selben Herstellungsprozess mitausgebildet werden oder nach dem Herstellungsprozess gebohrt/geschnitten werden. In diesem Fall ist der Kühlkörper besonders zuverlässig, da er - selbst ohne spezielle Dichtungsmaßnahmen - abseits der Öffnungen fluidisch dicht ist. Denn das Kühlmittel tritt nicht in unerwünschter Weise abseits der Öffnungen aus der Kühlmittelkammer aus und gelangt folglich nicht in die Umgebung des Kühlkörpers, sodass wirksam verhindert ist, dass das Kühlmittel außerhalb des Kühlkörpers Schaden verursacht.

Insbesondere ist das Kontaktierungselement mittels eines spanlosen Fertigungsverfahrens und/oder mittels eines spanenden Fertigungsverfahrens hergestellt. Mit anderen Worten kann der Kühlmittelkammeranteil mittels eines spanlosen Fertigungsverfahrens und/oder mittels eines spanenden Fertigungsverfahrens hergestellt sein. Alternativ oder zusätzlich kann der Kühlmittelkammerdeckel mittels eines spanlosen Fertigungsverfahrens und/oder mittels eines spanenden Fertigungsverfahrens hergestellt sein. Insbesondere ist der Kühlmittelkammeranteil mittels Kaltfließpressens hergestellt. Ferner ist ein additives bzw. generatives Fertigungsverfahren sowohl für den Kühlmittelkammeranteil und/oder den Kühlmittelkammerdeckel denkbar, zum Beispiel ein 3D-Drucken, ein pulverbettbasiertes (Laser-)Schmelzen etc. Ferner kommt ein Fräsen etc. in Frage, insbesondere zum Nachbearbeiten eines Kühlmittelkammerrohanteils des Kühlrohkörpers, nachdem der Kühlmittelkammerrohanteil spanlos hergestellt wurde. Hierdurch kann das Kontaktierungselement, insbesondere dessen Kühlkörper, besonders einfach und effizient hergestellt werden. Darüber hinaus kann eine Oberflächenbearbeitung bzw. -veredelung erfolgen, beispielsweise kann der Kühlkörper außenseitig und/oder innenseitig mit einer Korrosionsschutzbeschichtung beschichtet sein. Ferner ist es denkbar, dass die Kühlmittelkammer mit einer innenseitigen strömungsbeeinflussenden Oberflächenstruktur ausgebildet ist, zum Beispiel mit Strömungsrippen oder sonstigen Strömungslenkelementen. So wird dem Gedanken an einen effizienten kühlmittelbasierten Wärmeabtransport in besonderem Maße Rechnung getragen.

Des Weiteren weist das Kontaktierungselement eine Einströmöffnung und eine davon separat ausgebildete Ausströmöffnung auf, wobei die Einströmöffnung den Kühlkörper, insbesondere dessen Kühlmittelkammerdeckel, durchdringt und in die Kühlmittelkammer mündet. Die Einströmöffnung ist dazu eingerichtet, außenseitig des Kühlkörpers mit einem Zulaufkanal eines Kühlmittelkreislaufs, der beispielsweise Teil der Steckverbindungseinrichtung oder des Kraftfahrzeugs sein kann, fluidisch verbunden zu werden. Die Ausströmöffnung durchdringt den Kühlkörper, insbesondere dessen Kühlmittelkammerdeckel, an anderer Stelle als die Einströmöffnung und mündet ebenfalls in die Kühlmittelkammer. Die Ausströmöffnung ist dazu eingerichtet, außenseitig des Kühlkörpers mit einem Rücklaufkanal des Kühlmittelkreislaufs fluidisch verbunden zu werden. Der Kühlmittelkreislauf der Steckverbindungseinrichtung weist ein Kühlmittelkanalwerk (zum Beispiel ein Rohr- und/oder Schlauchwerk) und ein fluidisch in das Kühlmittelkanalwerk integriertes Kühlmittelantriebselement (eine Kühlmittelpumpe, falls als Kühlmittel eine Kühlflüssigkeit eingesetzt wird, oder ein Kühlmittelgebläse, falls als Kühlmittel ein Kühlgas eingesetzt wird) auf.

Die Einströmöffnung und die Ausströmöffnung sind beispielsweise kreisrund ausgebildet und können gemeinsam mit dem Kühlkörper, insbesondere dessen Kühlmittelkammerdeckel, urgeformt sein. Die Öffnungen, das heißt die Einströmöffnung und die Ausströmöffnung, können zum Beispiel im Rahmen eines generativen und/oder additiven Herstellens des Kühlkörpers (oder eines Teils davon) oder im Rahmen eines Gießens eines Kühlrohkörpers (oder eines Teils davon) ausgebildet werden. Bei dem Kühlrohkörpers kann es sich um ein Zwischenprodukt handeln, das zum Herstellen des Kühlkörpers spanend und/oder spanlos nachbearbeitet werden kann. Die Öffnungen können alternativ in einem separaten Herstellungsprozessschritt (das heißt nach dem Urformen des Kühlkörpers bzw. Kühlrohkörpers) gebildet worden sein, etwa mittels Bohrens und/oder Honens und/oder Schneidens (insbesondere Laserschneidens) und/oder Fräsens und/oder Stanzens etc. einer entsprechenden Wand des Kühlkörpers bzw. Kühlrohkörpers. Die Kühlmittelkammer ist nach außen hin - abgesehen von den beiden Öffnungen - fluidisch dicht, sodass abseits der Öffnungen ein Austreten des Kühlmittels aus der Kühlmittelkammer heraus in eine Umgebung des Kühlkörpers verhindert ist. Die Öffnungen können beide in dem Kühlmittelkammerdeckel ausgebildet sein. Alternativ kann vorgesehen sein, dass eine der Öffnungen, beispielsweise die Einströmöffnung, den Kühlmittelkammerdeckel durchdringt, wohingegen die entsprechend andere der Öffnungen, etwa die Ausströmöffnung, den Kühlmittelkammeranteil durchdringt. Auch eine Ausführung des Kühlkörpers, bei dem die beiden Öffnungen den Kühlmittelkammeranteil durchdringen, ist denkbar.

Zudem weist das Kontaktierungselement ein erstes Verbindungselement auf, das dazu eingerichtet ist, mit einem korrespondierenden, zweiten Verbindungselement der Steckverbindungseinrichtung eine flächige kraft-, form- und/oder stoffschlüssige sowie elektrisch leitende und wärmeleitende Verbindungsvorrichtung zwischen einer Kontaktierungsfläche des Kühlkörpers und einer korrespondierenden Kontaktierungsfläche einer Stromschiene zu bilden. Demnach liegen bei der Steckverbindungseinrichtung die beiden miteinander korrespondierenden Kontaktierungsflächen und infolgedessen das Kontaktierungselement und die entsprechende Stromschiene aneinander an. Für die Steckverbindungseinrichtung gilt, dass deren Stromschiene einen Stromschienenhauptkörper und einen Stromschienenadapterkörper aufweisen kann, wobei die der Stromschienenadapterkörper die Kontaktierungsfläche der Stromschiene und das zweite Verbindungselement der Steckverbindungseinrichtung aufweist. Folglich können das Kontaktierungselement, insbesondere dessen Kühlkörper, und der Stromschienenadapterkörper miteinander elektrisch leitend und wärmeleitend verbunden sein, indem das Kontaktierungselement und die Stromschiene mittels des Stromschienenadapterkörpers miteinander elektrisch leitend und wärmeleitend verbunden sind.

Insbesondere werden die Kontaktierungsflächen aneinandergespannt, etwa indem das zweite Verbindungselement als ein Schraubbolzen mit Außengewinde ausgeführt ist, der kraft-, form- und/oder stoffschlüssig mit der Stromschiene verbunden ist. Der Schraubbolzen erstreckt sich durch das in diesem Fall als Durchgangsloch ausgebildete erste Verbindungselement, das heißt durch den Kühlkörper. Denn das Durchgangsloch durchdringt den Kühlkörper. Ein Kopfanteil des Schraubbolzens liegt dann an einer der Kontaktierungsfläche abgewandten Fläche des Kontaktierungselements auf und spannt das Kontaktierungselement an sie Stromschiene, wodurch die Kontaktierungsflächen aneinandergespannt sind. Bei dem Schraubbolzen kann es um einen Stehbolzen handeln, der einstückig mit der Stromschiene ausgebildet ist, oder in die Stromschiene eingeschraubt oder anderweitig mit der Stromschiene kraft-, form- und/oder stoffschlüssig verbunden ist; dann handelt es sich bei dem Kopfanteil um eine Schraubmutter. Alternativ kann es sich bei dem Sachraubbolzen um einen Bolzenteil einer Schraube handeln, wobei ein Bolzenanteil der Schraube und der als Schraubenkopf ausgebildete Kopfanteil einstückig miteinander ausgebildet sind. Ferner ist es denkbar, dass das erste Verbindungselement als eine Innengewindeöffnung ausgebildet ist (etwa in Form einer Gewindehülse oder -buchse, die in einen korrespondierenden Hülsen- bzw. Buchsensitz des Kühlkörpers eingesetzt ist, insbesondere eingepresst und/oder anders kraft-, form- und/oder stoffschlüssig integriert ist, in Form eines direkt in das Material des Kühlkörpers geformtes/geschnittenes Innengewinde etc.) und das zweite Verbindungselement einen (anderen) Schraubbolzen sowie eine mit dem Schraubbolzen korrespondierende Schraubbolzenöffnung aufweist. Dann ist der Bolzenanteil dieses Schraubbolzens einerseits in die Innengewindeöffnung des Kühlkörpers bzw. in das erste Verbindungselement eingeschraubt und ragt andererseits durch die Schraubbolzenöffnung hindurch und über diese hinaus. Mittels eines (anderen) Kopfanteils (Schraubmutter oder Schraubenkopf) ist dann die Stromschiene an den Kühlkörper gespannt, wodurch die Kontaktierungsflächen aneinandergespannt sind. Alternativ oder zusätzlich kann zwischen den Kontaktierungsflächen eine Schweißverbindung ausgebildet sein, die zum Beispiel mittels Reib-, Ultraschall- und/oder Laserschweißens erzeugt ist. Es kommt weiter in Frage, zwischen den Kontaktierungsflächen einen elektrisch leitfähigen Klebstoff, insbesondere eine Wärmeleitpaste, zu applizieren, sodass die Kontaktierungsflächen mittels einer Klebeverbindung aneinander befestigt sind.

Hierdurch ist eine Möglichkeit geschaffen, um das Kontaktierungselement besonders wirksam und effizient aktiv zu kühlen. Denn im Betrieb des Kontaktierungselements bzw. der Steckverbindungseinrichtung wird die Kühlmittelkammer mit dem Kühlmittel durchströmt bzw. durchspült, wodurch Wärme aus dem Material des Kühlkörpers in das die Kühlmittelkammer durchströmende Kühlmittel übergeht und mittels des Kühlmittels abtransportiert wird. Die Wärme, die mittels des Kühlmittels von dem Kühlkörper, also aus der Kühlmittelkammer, abtransportiert wird, ist insbesondere Wärme, die aufgrund eines den Kühlkörper durchfließenden elektrischen Stroms im Material des Kühlkörpers erzeugt und über die Befestigungseinrichtung in das Material des Kühlkörpers geleitet wird. Zudem wird Wärme, die aufgrund eines die Stromschiene durchfließenden elektrischen Stroms im Material der Stromschiene erzeugt wird, über die Kontaktierungsflächen in den Kühlkörper und folglich in das Kühlmittel geleitet, was bedeutet, dass die Stromschiene ebenfalls besonders effizient mittels des Kontaktierungselements im Betrieb gekühlt wird. Um den Wärmeübergang zwischen Kühlkörper und der Stromschiene, das heißt zwischen den Kontaktierungsflächen, sowie zwischen dem Kühlkörper und dem Kühlmittel zu begünstigen, ist vorgesehen, dass als das jeweilige elektrisch leitfähige Material des Kühlkörpers und der Stromschiene ein solches gewählt wird, das einen besonders hohe Wärmeleitfähigkeit aufweist, Indem im Betrieb der Kühlkörper und die Stromschiene aktiv mittels des Kühlmittels gekühlt werden, wird einem Erhöhen des ohmschen Widerstands aufgrund des fließenden Stroms wirksam entgegengewirkt, sodass im Vergleich mit ungekühlten oder passivgekühlten stromführenden Elementen besonders hohe Lade- und/oder Entladeleistungen darstellbar sind. Zusätzlich weist der Kühlkörper eine Doppelfunktionalität auf, da er im Betrieb - erstens - als Wärmesenke für die Stromschiene fungiert und - zweitens - als stromführendes Element fungiert. So ist ein besonders effizientes Kühlen ermöglicht, da das stromführende Element selbst, also der Kühlkörper selbst, direkt mit dem Kühlmittel durchströmt wird. Ferner ist der Kühlkörper besonders bauraumeffizient und ausgebildet.

Insbesondere weist das Kontaktierungselement einen Kontaktierungspin auf, der außenseitig an dem Kühlkörper gehalten oder halterbar ist. Der Kontaktierungspin ist aus einem elektrisch leitfähigen Material ausgebildet, bei dem es sich beispielsweise um das gleiche Material wie bei dem Kühlkörper handeln kann. Ferner kann der Kontaktierungspin als ein Hohlpin ausgeführt sein, dessen Kontaktierungsabschnitt in Form eines geraden Kreisringzylinders ausgeführt ist. Ferner ist ein Vollpin denkbar, dessen Kontaktierungsabschnitt in Form eines geraden Kreiszylinders ausgeführt ist. Auch ein anderer Querschnitt des Kontaktierungsabschnitts ist denkbar, zum Beispiel ein elliptischer, ovaler, polygonaler Querschnitt. Der Kontaktierungspin ist zum Beispiel mittels einer Befestigungseinrichtung des Kontaktierungselements, die am Kühlkörper ausgebildet ist außenseitig am Kühlkörper kraft-, form- und/oder stoffschlüssig fixiert und dabei mit dem Kühlkörper elektrisch kontaktiert. Insoweit fungiert die Befestigungseinrichtung als mechanische Befestigungseinrichtung, mittels derer der Kontaktierungspin am Kühlkörper mechanisch positionsfest gehalten ist, und gleichzeitig als elektrische Kontaktierungseinrichtung, mittels derer der Kontaktierungspin und den Kühlkörper elektrisch miteinander kontaktiert sind. Die Befestigungseinrichtung kann eine Innengewindehülse oder-buchse aufweisen, deren Innengewinde mit einem Außengewinde des Kontaktierungspins korrespondiert, wobei die Innengewindehülse und ein Hülsensitz bzw. Buchsensitz der Befestigungseinrichtung miteinander einen Pressverband bilden. Insoweit ist also die Innengewindehülse in den Hülsensitz eingepresst. Dabei kann ein Längspressverband und/oder oder ein Querpressverband hergestellt sein. Bei letzterem kann Aufschrumpfen und/oder Kaltdehnen zum Herstellen des Pressverbandes eingesetzt werden. So kann der Kontaktierungspin auf besonders einfache Art in die Befestigungseinrichtung eingeschraubt werden, nämlich in die Gewindehülse. Alternativ kann der Kontaktierungspin direkt in den Hülsensitz eingepresst werden, wofür dann der Kontaktierungsabschnitt des Kontaktierungspins (ohne Hülse) als Pressverbandpartner für den Pressverband fungiert. Das Ausbilden des Außen- und des Innengewindes entfallen in dem Fall. Die Befestigungseinrichtung weist beispielsweise eine Spanneinheit auf, in deren Pinaufnahme ein Ende des Kontaktierungspins eingesetzt ist. Zu der Spanneinheit gehört zudem eine Überwurfmutter, mittels derer das Ende des Kontaktierungspins an/in die Pinaufnahme gespannt ist, sodass zwischen Ende des Kontaktierungspins und der Pinaufnahme eine kraftschlüssige und elektrisch leitende Verbindung hergestellt ist. Zumindest ein Teil der und der Kühlkörper, insbesondere dessen Kühlmittelkammeranteil, sind einstückig miteinander ausgebildet.

Alternativ können das Kontaktierungselement, insbesondere dessen Kühlkörper, und der Kontaktierungspin einstückig miteinander ausgebildet sein. In diesem Zusammenhang ist zu verstehen, dass es sich bei der Befestigungseinrichtung insbesondere um einen Materialbereich handeln kann, in den ein Material des Kontaktierungspins nahtlos in ein Material des Kontaktierungselements bzw. Kühlkörpers übergeht. Das den Kontaktierungspin und der damit einstückig ausgebildete Kühlkörper aufweisende Kontaktierungselement stellt eine besonders stabile und zuverlässige sowohl elektrische als auch mechanische Verbindung zwischen dem Kühlkörper und dem Kontaktierungspin bereit. Zudem ist das Kontaktierungselement besonders einfach, nämlich mittels besonders weniger Prozessschritte, herstellbar.

Das Kontaktierungselement weist insbesondere für eine der Öffnungen ein Kanalkopplungselement auf. Insbesondere weist das Kontaktierungselement ein für die Einströmöffnung vorgesehenes, erstes Kanalkopplungselement und ein für die Ausströmöffnung vorgesehenes, zweites Kanalkopplungselement auf. Ein jeweiliges erstes Ende des jeweiligen Kanalkopplungselements schließt sich außenseitig der Kühlmittelkammer fluidisch an die entsprechende Öffnung an. Alternativ kann das jeweilige erste Ende des jeweiligen Kanalkopplungselements in die entsprechende Öffnung eingesetzt sein. Das jeweilige erste Ende kann in die Kühlmittelkammer hineinragen, das heißt von einer Wand des Kühlkörpers, durch die die entsprechende Öffnung in die Kühlmittelkammer mündet, in die Kühlmittelkammer hinein hervorspringen. Ein jeweiliges zweites Ende des jeweiligen Kanalkopplungselements ist dazu eingerichtet, mit dem entsprechenden Kanal, das heißt mit dem Zulaufkanal oder mit dem Rücklaufkanal, des Kühlmittelkreislaufs fluidisch verbunden zu werden. Das jeweilige Kanalkopplungselement ist zum Beispiel separat von dem Kühlkörper, folglich separat von den Öffnungen ausgebildet und dann in die entsprechende Öffnung eingesetzt oder an die entsprechende Öffnung angesetzt und insbesondere an/in besagter Öffnung fixiert. Das Kanalkopplungselement kann beispielsweise in die entsprechende Öffnung eingeschraubt sein, wofür das Kanalkopplungselement dann an dessen erstem Ende ein Außengewinde aufweist und die entsprechende Öffnung ein mit dem Außengewinde zum Herstellen einer Gewinde- bzw. Schraubverbindung korrespondierendes Innengewinde aufweist. Für ein besonders einfaches Einschrauben des Kanalkopplungselements, insbesondere mithilfe eines Schraubwerkzeugs, kann das Kanalkopplungselement außenumfangsseitig ein Angriffselement für ein Schraubwerkzeug, etwa einen Vielkantkörper, aufweisen. Alternativ oder zusätzlich kann das Kanalkopplungselement unter Ausbildung eines Längs- oder Querpressverbands in die entsprechende Öffnung eingepresst sein. Wiederum alternativ oder zusätzlich kann das Kanalkopplungselement an/in die entsprechende Öffnung an-/eingeschweißt sein (beispielsweise mittels Reib-, Ultraschall- und/oder Laserschweißens), an-/eingeklebt, an-/eingelötet etc. In den Fällen, in denen das Kanalkopplungselement in die entsprechende Öffnung eingesetzt oder eingelegt ist, kann das Kanalkopplungselement einen Kragen aufweisen, der außenseitig an dem Kühlkörper zum Anliegen kommt, wodurch eine bestimmungsgemäße Einbaulage des Kanalkopplungselements sichergestellt ist. Das Kanalkopplungselement und die entsprechend zugehörige der Öffnungen können gemeinsam mit dem Kühlkörper, insbesondere dessen Kühlmittelkammerdeckel, urgeformt sein. Das Kanalkopplungselement kann zum Beispiel im Rahmen des generativen und/oder additiven Herstellens des Kühlkörpers (oder eines Teils davon) oder im Rahmen des Gießens des Kühlrohkörpers (oder eines Teils davon) ausgebildet werden. Ferner kann das Kanalkopplungselement im Rahmen eines Nachbearbeitens des Kühlrohkörpers oder des Kühlkörpers spanend und/oder spanlos ausgebildet werden. Aufgrund des jeweiligen Kanalkopplungselements ist das Kühlmittelkanalwerk des Kühlmittelkreislaufs, das heißt das Rohr- und/oder Schlauchwerk, auf besonders einfache bzw. aufwandsarme Weise an die Öffnungen und infolgedessen an die Kühlmittelkammer fluidisch anschließbar. Zudem kann das jeweilige Kanalkopplungselement als ein Winkelstück ausgeführt sein, sodass die Kanäle des Kühlmittelkanalwerks besonders vorteilhaft verlegt werden können.

Zudem kann ein Sensorsitz vorgesehen sein, der außen am Kühlmittelkammeranteil angeordnet und dazu eingerichtet ist, einen Temperatursensor einer Temperaturmesseinrichtung zum Messen einer Temperatur des Kontaktierungselements aufzunehmen. Die Temperaturmesseinrichtung ist zum Beispiel Teil des Kraftfahrzeugs oder der Steckverbindungseinrichtung. Sie ist dazu eingerichtet, im Betrieb des Kontaktierungselements bzw. der Steckverbindungseinrichtung eine Betriebstemperatur zu überwachen. Durch die hierin beschriebene Anordnung des Temperatursensors kann besonders sicher und zuverlässig eine Temperatur des Kontaktierungselements bzw. der Steckverbindungseinrichtung gemessen werden. Bei einer Überhitzung kann eine vorgegebene Gegenmaßnahme eingeleitet werden, beispielsweise ein Verringern der Lade-/Entladeleistung, ein Erhöhen einer Kühlleistung, ein Abbrechen des Lade-/Entladevorgangs etc. Da das Material des Kühlkörpers und das Material des Kontaktierungspins besonders gut wärmeleitend sind, ist der Temperatursensor am Kühlmittelkammeranteil hinsichtlich seiner Einbauposition besonders vorteilhaft, da die Temperatur des Kontaktierungspins und/oder des Kühlkörpers besonders genau gemessen werden kann. Zudem ist der Temperatursensor, da er außenseitig an dem Kühlkörper angeordnet ist, besonders einfach erreichbar/zugänglich. So kann der Temperatursensor mit einem Schaltungsträger, zum Beispiel einer Platine, der Steckverbindungseinrichtung besonders aufwandsarm elektrisch kontaktiert werden, insbesondere direkt auf den Schaltungsträger bzw. auf die Platine aufgesetzt werden. Dadurch ist eine besonders einfache Herstellung, insbesondere eine ganz oder teilweise automatisierte, etwa roboterunterstützte Herstellung des Kontaktierungselements und infolgedessen der Steckverbindungseinrichtung unterstützt.

Der Sensorsitz weist eine in vorteilhafter Weise besonders einfache Struktur auf und lässt sich besonders einfach und/oder aufwandsarm fertigen, wenn er ein in den Kühlmittelkammeranteil gebildetes Sackloch aufweist. Ein Innendurchmesser des Sacklochs korrespondiert zumindest mit einem Außendurchmesser eines Sensorkopfes des Temperatursensors, über welchen der Temperatursensor in das Sackloch, das heißt in den Kühlmittelkammeranteil des Kühlkörpers, aufgenommen ist. Es kann vorgesehen sein, dass der Sensorkopf in das Sackloch eingesetzt ist, dabei eine Innenumfangsfläche des Sacklochs wärmeleitend berührt und positionell in dem Sackloch gehalten wird, indem der Schaltungsträger, auf/an dem der Temperatursensor fixiert ist, in Bezug zu dem Kühlkörper fixiert ist. Alternativ oder zusätzlich ist der Einsatz einer kraft-, form- und/oder stoffschlüssigen Verbindung zwischen dem Sensorkopf und dem Sackloch denkbar, etwa dass der Sensorkopf in das Sackloch eingepresst, eingeklebt etc. ist.

Insbesondere sind der Sensorsitz und die Befestigungseinrichtung oder der Sensorsitz und der Kontaktierungspin an einer gemeinsamen Fläche des Kühlmittelkammeranteils angeordnet. Beispielsweise weist der Kühlmittelkammeranteil eine Stirnfläche auf, an der die Befestigungsrichtung angeordnet ist bzw. der Kontaktierungspin fußt, insbesondere sich von der Stirnfläche wegerstreckt. Dies ist insbesondere bei einer asymmetrischen Außengestalt des Kühlkörpers von Vorteil, da die Stirnfläche in diesem Fall einen für den Sensorkopf ausreichen großen freien Bereich aufweist, der an die Befestigungseinrichtung angrenzt. So kann der Sensorkopf besonders nah an die Befestigungseinrichtung bzw. besonders nah an den Kontaktierungspin, angebracht werden.

Eine mögliche Weiterbildung des Kontaktierungselements sieht vor, dass - zumindest wenn die Verbindungsvorrichtung als zweites Verbindungselement den Schraubbolzen, die Innengewindehülse und/oder dergleichen erfordert, mittels dessen die Kontaktierungsflächen aneinandergespannt werden - das erste Verbindungselement eine Senke oder Mulde aufweist. Die Senke oder Mulde ist derart ausgebildet, dass die Verbindungsvorrichtung bzw. ein Teil derselben, zum Beispiel der Kopfanteil der Schraube eine Schraubbolzenspitze, ein Hülsenrand der Innengewindehülse etc., aufgenommen wird. Der entsprechende Teil der Verbindungsvorrichtung taucht infolgedessen an einer Fläche, die von der Kontaktierungsfläche des Kühlkörpers abgewandt ist, vollständig in eine vorgegebene Außenkontur ein bzw. steht nicht über besagte Außenkontur übersteht oder springt nicht von dieser hervor. Dies ist insofern vorteilhaft, als bei einem vorgegebenen Pitch-Maß (das ist ein gerader Abstand zwischen zwei direkt zueinander benachbarten Kontaktierungspins derselben Steckverbindungsvorrichtung) eine besonders voluminöse und damit den Wärmeabtransport besonders effizient unterstützende Kühlmittelkammer erreicht wird. Das Pitch-Maß kann zudem besonders klein vorgegeben werden, da kein Bauraum für die Verbindungsvorrichtung vorgesehen werden muss, der zwischen den beiden direkt zueinander benachbarten Kontaktierungselenenten über die jeweilige vorgegebene Außenkontur hervorspringt. Dadurch ist eine besonders bauraumeffiziente Ausgestaltung des Kühlkörpers und infolgedessen des Kontaktierungselements ermöglicht.

Gemäß einer weiteren möglichen Ausgestaltung des Kontaktierungselements weist die Kühlmittelkammer eine Einströmteilkammer, eine Ausströmteilkammer sowie einen Verbindungskanal auf. Die Ausströmteilkammer und die Einströmteilkammer sind voneinander beabstandet und mittels des Verbindungskanals fluidisch miteinander verbunden. Der Verbindungskanal ist verglichen mit den Teilkammern schmal ausgeführt. So wird ein besonders vorteilhafter Strömungspfad für das Kühlmittel geschaffen, was zu einer besonders effizienten Entwärmung des Kontaktierungselements, insbesondere dessen Kühlkörpers, und der Stromschiene führt.

Sofern das erste Verbindungselement die Senke aufweist, ist in weiterer möglicher Ausgestaltung des Kontaktierungselements vorgesehen, dass die Senke/Mulde zwischen der Einströmteilkammer und der Ausströmteilkammer in den Kühlkörper eintaucht. Die Teilkammern sind in anderen Worten über die Senke voneinander beabstandet. Dadurch ergibt sich eine besonders bauraumeffiziente Gestalt des Kontaktierungselements. Zudem ist das Kontaktierungselement in diesem Fall besonders materialeffizient hergestellt, da zwischen der Einströmteilkammer und der Ausströmteilkammer aufgrund der Mulde bzw. Senke besonders wenig Material erforderlich ist, wobei dennoch ein (eventuell jeweils vorgegebenes) Volumen der Teilkammern ermöglicht ist.

Wenn die Teilkammern mittels der Senke voneinander beabstandet sind, schlägt eine weitere mögliche Ausgestaltung des Kontaktierungselements vor, dass eine Längsmittenachse der Einströmteilkammer, insbesondere der Einströmöffnung, und eine Längsmittenachse des Kontaktierungspins bzw. der Befestigungseinrichtung des Kontaktierungselements zusammenfallen, wobei eine Längsmittenachse der Ausströmteilkammer und die Längsmittenachse der Einströmteilkammer auseinanderfallen. Anders ausgedrückt bildet die Längsmittenachse der Einströmteilkammer, insbesondere der Einströmöffnung, in axialer Verlängerung die Längsmittenachse der Befestigungseinrichtung bzw. des Kontaktierungspins (bzw. umgekehrt). Dabei ist die Längsmittenachse der Ausströmteilkammer insbesondere parallelversetzt. Das bedeutet für den Betrieb des Kontaktierungselements bzw. der Steckverbindungseinrichtung, dass das Kühlmittel unter dem Einströmen in die Kühlmittelkammer, insbesondere in dessen Einströmteilkammer, (bzw. direkt danach) einen Wandbereich der Kühlmittelkammer anströmt, über welchen die Befestigungseinrichtung oder der Kontaktierungspin und die Kühlmittelkammer in gerader Linie voneinander abgegrenzt sind. Hierdurch wir der Wandbereich besonders effizient entwärmt, was zu einer besonders effizienten Kühlung des Kontaktierungspins führt.

Das Kontaktierungselement, insbesondere dessen Kühlkörper, ist generell so ausgebildet, dass dessen Struktur frei von einem Hinterschnitt ist, wodurch das Herstellen mittels Kaltfließpressens begünstigt ist. Gemäß einer möglichen Weiterbildung ist der Verbindungskanal zum einen durch den Kühlmittelkammeranteil und zum anderen durch den Kühlmittelkammerdeckel begrenzt. Hierdurch steht die Ausbildung des Verbindungskanals der hinterschnittfreien Gestalt des Kontaktierungselement nicht entgegen. Zudem ist der Verbindungskanal besonders einfach öffenbar, etwa zu Reinigungs- und/oder Reparaturzwecken.

An der Einströmöffnung und/oder an der Ausströmöffnung ist in Weiterbildung des Kontaktierungselements eine (jeweilige) sich in die Kühlmittelkammer hineinerstreckende längliche Kühlmittellanze des Kontaktierungselements angeordnet, die mit dem Kühlmittel durchströmbar ist. Eine erste Lanzenmündung der Kühlmittellanze ist fluidisch mit einer kühlmittelkammerseitigen Mündung der entsprechenden Öffnung verbunden, wobei eine zweite Lanzenmündung der Kühlmittellanze und die kühlmittelkammerseitige Mündung über eine freie Lanzenlänge voneinander beabstandet sind. Im Betrieb gilt also, dass das Kühlmittel aus dem Zulaufkanal durch die Einströmöffnung strömt, wodurch es zwangsläufig durch die einströmöffnungsseitige Kühlmittellanze strömt. Mit anderen Worten strömt das Kühlmittel in die Kühlmittelkammer bzw. in die Einströmteilkammer, ein, indem es durch die Einströmöffnung hindurchströmt, unter einem Ausströmen aus der kühlmittelkammerseitigen Mündung der Einströmöffnung in die erste Lanzenmündung einströmt und infolgedessen aus der zweiten Lanzenmündung ausströmt. Für das im Betrieb ausströmende Kühlmittel gilt, dass es - um aus der Kühlmittelkammer in den Rücklaufkanal einzuströmen - zunächst in die zweite Lanzenmündung der ausströmöffnungsseitigen Kühlmittellanze einströmt, die Kühlmittellanze durchströmt und unter einem Ausströmen aus der ersten Lanzenmündung in die kühlmittelkammerseitige Mündung der Ausströmöffnung einströmt. Die Lanzenlänge ist dabei jeweils so gewählt, dass im Betrieb ein besonders hoher Füllgrad der Kühlmittelkammer - insbesondere der Teilkammern - erreicht wird und/oder besonders wirksame Kühlmittelströmungsformen in der Kühlmittelkammer bzw. in den Teilkammern auftreten, wodurch der Wärmeabtransport besonders effizient erfolgt. In weiterer Ausgestaltung weist die jeweilige Kühlmittellanze eine Längsschnittfigur auf, durch welche im Betrieb ein besonders vorteilhafter statischer Druck und/oder eine besonders vorteilhafte Strömungsgeschwindigkeit des aus der entsprechenden Lanzenmündung ausströmenden Kühlmittels erzeugt werden/wird. Beispielsweise kann die einströmöffnungsseitige Kühlmittellanze an der zweiten Lanzenmündung einen engeren Querschnitt aufweisen als an der ersten Lanzenmündung. So wird der Wärmeabtransport mittels des Kühlmittels nochmals gesteigert.

Das Kontaktierungselement weist in weiterer möglicher Ausführungsform ein erstes Fixierungselement auf, das insbesondere von dem Kühlkörper hervorspringt und jedenfalls mit einem zweiten Fixierungselement der Steckverbindungseinrichtung oder des Kraftfahrzeugs zum Bilden einer Fixierungseinrichtung korrespondiert. Mittels der Fixierungseinrichtung ist das Kontaktierungselement positionell fixierbar. Das erste Fixierungselement kann beispielsweise einen Fixierungszapfen aufweisen, wobei dann das zweite Fixierungselement eine Zapfenaufnahme aufweist, in die der Fixierungszapfen passend einsetzbar oder - bei der Steckverbindungseinrichtung - eingesetzt ist. Ferner kann das erste Fixierungselement einen Schraubstehbolzen aufweisen, der von dem Kühlkörper hervorspringt, durch eine entsprechend zugeordnete Schraubbolzenöffnung - eines Trägerelements des Kraftfahrzeugs oder der Steckverbindungseinrichtung - hindurchragt und mit einer Schraubmutter gegen ein Herausbewegen aus der Schraubbolzenöffnung gesichert ist. Durch das Trägerelement erstreckt sich insbesondere der Kontaktierungspin bzw. dessen Befestigungseinrichtung hindurch, wobei die Befestigungseinrichtung bzw. der Kontaktierungspin in einem Fixierungsabschnitt analog zu dem ersten Fixierungselement ausgeführt sein kann. Hierdurch weist das Kontaktierungselement, insbesondere dessen Fixierungseinrichtung, zwei analog ausgebildete Fixierungskörper auf, wobei dann vorgesehen ist, dass die Steckverbindungseinrichtung eine mit dem Fixierungsabschnitt korrespondiere Fixierungsabschnittaufnahme aufweist. Kommt es im Betrieb der Steckverbindungseinrichtung zu einem auf das Kontaktierungselement wirkenden Kipp- und/oder Drehmoment, ist aufgrund der Fixierungseinrichtung wirksam verhindert, dass das Kontaktierungselement sich verdreht oder kippt, da es mittels der Fixierungseinrichtung positionell gesichert ist, insbesondere an dem Trägerelement. Das erste Fixierungselement und der Fixierungsabschnitt sind insbesondere über einen Hebelabstand voneinander beabstandet, der so vorgegeben ist, dass zu erwartende Kipp- und/oder Drehmomente besonders effizient über die Fixierungseinrichtung aufgenommen werden kann.

In Fällen, in denen die Kühlmittelkammer die beiden Teilkammern aufweist, ist in Weiterbildung dieser Ausführungsform vorgesehen, dass eine Längsmittenachse des ersten Fixierungselements und die Längsmittenachse der Ausströmteilkammer zusammenfallen, wodurch dem Gedanken an ein besonders bauraumeffizient bzw. kompakt ausgebildetes Kontaktierungselement besonders Rechnung getragen wird.

Die erfindungsgemäße Steckverbindungseinrichtung weist eine Stromschiene und eine weitere Stromschiene sowie als ein erstes Kontaktierungselement das hierin beschrieben Kontaktierungselement oder eine mögliche Ausführungsform davon auf. Die Kontaktierungsfläche des ersten Kontaktierungselements und die korrespondierenden Kontaktierungsfläche der Stromschiene sind mittels der Verbindungsvorrichtung, das heißt mittels des ersten und des zweiten Verbindungselements, elektrisch und wärmeleitend kraft-, form- und/oder stoffschlüssig miteinander verbunden. Ferner weist die Steckverbindungseinrichtung ein weiteres Kontaktierungselement auf, das insbesondere gleich dem ersten Kontaktierungselement ausgebildet und analog zu dem ersten Kontaktierungselement mit der weiteren Stromschiene verbunden ist. Von besonderem Vorteil ist es, wenn die Kontaktierungselemente als Gleichteile ausgebildet sind. Hierzu ist bei dem Kontaktierungselement insbesondere generell vorgesehen, dass es symmetrisch in Bezug zu einer mittigen Symmetrieebene ausgebildet ist, wobei in der Symmetrieebene insbesondere die Längsmittenachse liegen.

Zudem weist die Steckverbindungseinrichtung den mit dem Kühlmittel durchströmbaren Kühlmittelkreislauf auf, der das Kühlmittelkanalwerk umfasst. Das erste und/oder das zweite Kontaktierungselement sowie die Stromschiene und/oder die weitere Stromschiene sind im Betrieb der Steckverbindungseinrichtung - zum Beispiel in einem Lade- und/oder Entladebetrieb, in dem die Traktionsbatterie des Kraftfahrzeugs elektrisch ge-/entladen wird - mittels des Kühlmittelkreislaufs kühlbar. Hierzu ist die Einströmöffnung mit dem Zulaufkanal des Kühlmittelkreislaufs fluidisch verbunden, wobei die Ausströmöffnung und der Rücklaufkanal des Kühlmittelkreislaufs fluidisch miteinander verbunden sind.

Zum Beispiel aufgrund von Anforderungen hinsichtlich Dichtigkeit und Kraft- bzw. Momenteinleitung in das Kontaktierungselement kann vorgegeben werden, dass die jeweilige Stromschiene und das jeweilige Kontaktierungselement nicht direkt, sondern indirekt miteinander verbunden sind. Hierzu weist eine der Stromschienen oder weisen die Stromschienen der Steckverbindungseinrichtung in einer möglichen Weiterbildung den Stromschienenhauptkörper und den Stromschienenadapterkörper auf. Dabei weist der entsprechende Stromschienenadapterkörper die Kontaktierungsfläche der entsprechenden Stromschiene und das zweite Verbindungselement der Steckverbindungseinrichtung auf. Mittels des entsprechenden Stromschienenadapterkörpers sind die Stromschiene und das entsprechend zugehörige Kontaktierungselement elektrisch und wärmeleitend miteinander verbunden. Der Stromschienenadapterkörper ermöglicht eine besonders hohe Flexibilität bzw. Vielfalt bei einer Anordnung des Kontaktierungselements und der Stromschiene zueinander, wodurch einer Packaging-Problematik wirksam begegnet werden kann. Zudem ist das jeweilige Kontaktierungselement von dem Stromschienenhauptkörper entkoppelt, wodurch eine Kraft- bzw. Momenteinwirkung, ausgehend von dem Stromschienenhauptkörper, auf die Kontaktierungspins und infolgedessen Taumelbewegungen derselben vorteilhaft minimiert sind.

Ein weiterer Vorteil für die Handhabung der Einzelteile beim Herstellen der Steckverbindungseinrichtung entsteht, wenn - wie in einer weiteren möglichen Ausgestaltung der Steckverbindungseinrichtung vorgesehen ist - der Stromschienenadapterkörper und ein weiterer Stromschienenadapterkörper einer weiteren Stromschiene der Steckverbindungseinrichtung als Gleichteile ausgebildet sind. Insbesondere ist das Herstellen der Stromschienenadapterkörper besonders effizient, wenn diese jeweils mittels Stanzbiegens gefertigt werden.

Die Stromschiene in Verlängerung und das erste Kontaktierungselement schließen einer weiteren Ausführungsform der Steckverbindungseinrichtung zufolge miteinander einen vorgegebenen Einbaulagewinkel ein, der von 0° (Winkelgrad) und 180° unterschiedlich ist. So kann noch effizienter auf die Packaging-Problematik bzw. auf einen vorgegebenen, beengten Bauraum reagiert werden, und die Kontaktierungselemente können je nach erforderlichem Einbaulagewinkel bedarfsgerecht angeordnet werden.

Nach einer möglichen Weiterbildung weist die Steckverbindungseinrichtung ein Gehäuse mit einer ersten Gehäusekammer für das erste Kontaktierungselement und einer zweiten Gehäusekammer für ein weiteres Kontaktierungselement auf. Das Gehäuse weist eine Abstützeinrichtung auf, mittels derer die Kontaktierungselemente positionsfest abgestützt sind. Dabei ist die Abstützeinrichtung dazu eingerichtet, auf die Kontaktierungselemente einwirkende Positionsänderungskräfte aufzunehmen. Solche Positionsänderungskräfte sind zum Beispiel Längenänderungskräfte, die aus einer thermisch induzierten Gestaltänderung der Stromschienen resultieren. Durch die Abstützung der Kontaktierungselemente, sodass die Positionsänderungskräfte ohne Lageänderung der Kontaktierungselemente in das Gehäuse, insbesondere dessen Abstützeinrichtung, abgeleitet werden, ist gewährleistet, dass die Kontaktierungspins sich nicht oder allenfalls in deren Lagetoleranzfeld bewegen. Das Gehäuse ist bzw. die Gehäusekammern sind so ausgelegt, dass der Zugang zu Befestigungselementen, über welche die Kontaktierungselemente und/oder die Stromschienen oder Stromschienenadapterkörper am/im Gehäuse befestigt sind, zugänglich bleibt. Das jeweilige Kontaktierungselement kann samt zugehöriger Stromschiene zum Beispiel unter einem Einschieben durch eine offene Gehäuseseite in das Gehäuse bzw. in die entsprechende Gehäusekammer hinein an der Abstützeinrichtung abgestützt werden. Das Gehäuse ist ferner dazu ausgebildet, eine elektrische Isolierung zwischen den Kontaktierungselementen bereitzustellen, weswegen das Gehäuse insbesondere aus einem elektrisch isolierenden Material, beispielsweise aus einem elektrisch nichtleitenden bzw. isolierenden Kunststoff, ausgeführt ist. Das Gehäuse weist somit eine vorteilhafte Multifunktionalität auf.

In einer weiteren möglichen Ausführungsform der Steckverbindungseinrichtung weist das Gehäuse eine Taumelstütze auf, die dazu eingerichtet ist, an dem Kontaktierungspin oder an dessen Befestigungseinrichtung befestigt zu werden, sodass der Kontaktierungspin sich durch ein Überwurfelement der Taumelstütze hindurcherstreckt und dadurch gegen ein Taumeln in Bezug zu dem Gehäuse gesichert ist. So ist der jeweilige Kontaktierungspin noch effizienter gegen ein Taumeln bzw. ein unerwünschtes Bewegen aus seinem Lagetoleranzfeld gesichert. Dadurch sind eine besonders hohe Funktions- und Bediensicherheit gewährleistet. Bei dem Überwurfelement der Taumelstütze kann es sich zum Beispiel um die Überwurfmutter handeln, mittels derer der Kontaktierungspin in der Befestigungseinrichtung fixiert ist. Alternativ, insbesondere wenn der Kühlkörper und der Kontaktierungspin einstückig miteinander ausgebildet sind, kann die Überwurfmutter auf einen Muttersitz der Taumelstütze aufgeschraubt werden, der einstückig mit dem Kontaktierungspin und dem Kühlkörper ausgebildet ist. Jedenfalls wird die Überwurfmutter auf den Muttersitz oder auf die Pinaufnahme aufgeschraubt, nachdem der Kontaktierungspin durch eine Taumelstützenöffnung der Taumelstütze hindurchragt.

Durch die vorliegende Beschreibung wird zudem ein Baukastensystem zum Herstellen der Steckverbindungseinrichtung offenbart, wobei das Baukastensystem eine einzige Kontaktierungselementvariante aufweist, die gemäß dem hierin beschriebenen Kontaktierungselement ausgeführt ist. Das bedeutet, dass mithilfe des Baukastensystems unterschiedliche Steckverbindungseinrichtungsvarianten herstellbar sind, die variantenübergreifend die einzige Kontaktierungselementvariante, nämlich das Kontaktierungselement oder mehr Kontaktierungselemente aufweisen. Insbesondere weist das Baukastensystem unterschiedliche Varianten von Stromschienen und/oder unterschiedliche Varianten von weiteren Stromschienen und/oder unterschiedliche Varianten von Gehäusen auf. Die unterschiedlichen Varianten der Stromschienen unterscheiden sich zum Beispiel durch variantenspezifische Geometrien, eine variantenspezifische Struktur etc. Insbesondere unterscheiden sich die unterschiedlichen Varianten der Stromschienen in einem jeweiligen Einbaulagewinkel, den die Kontaktierungsfläche der jeweiligen Stromschienenvariante und eine Verlängerung derselben Stromschienenvariante miteinander definieren. Ferner können sich die Stromschienenvarianten unterscheiden, indem sie variantenspezifisch aus einem Stromschienenhauptkörper und dem Stromschienenadapterkörper gebildet sind, einstückig/monolithisch ausgeführt sind, etc. Die Gehäusevarianten unterscheiden sich beispielsweise durch unterschiedlich ausgebildete und/oder angeordnete Gehäusekammern, wobei die Anordnung der Gehäusekammern variantenspezifisch mit einer der Stromschienenvarianten, insbesondere hinsichtlich des Einbaulagewinkels, korrespondiert.

Weitere Vorteile, Merkmale und Einzelheiten der Erfindung können sich aus der nachfolgenden Beschreibung möglicher Ausführungsbeispiele sowie anhand der Zeichnung ergeben. Die vorstehend in der Beschreibung genannten Merkmale und Merkmalskombinationen sowie die nachfolgend in der Figurenbeschreibung und/oder in den Figuren alleine gezeigten Merkmale und Merkmalskombinationen sind nicht nur in der jeweils angegebenen Kombination, sondern auch in anderen Kombinationen oder in Alleinstellung verwendbar, ohne den Rahmen der Erfindung zu verlassen.

### Kurze Figurenbeschreibung

Die Zeichnung zeigt in:
- Fig. 1: eine perspektivische und entlang einer Symmetrieebene geschnittene Ansicht eines Kontaktierungselements für eine Steckverbindungseinrichtung,
- Fig. 2: eine perspektivische Ansicht des Kontaktierungselements,
- Fig. 3: eine perspektivische Ansicht der Steckverbindungseinrichtung, wobei eine Stromschiene in Verlängerung und das Kontaktierungselement miteinander einen vorgegebenen Einbaulagewinkel einschließen,
- Fig. 4: eine perspektivische Ansicht der Steckverbindungseinrichtung, und
- Fig. 5 bis Fig. 9: Varianten der Steckverbindungseinrichtung, jeweils in perspektivischer Ansicht.

Gleiche und funktionsgleiche Elemente sind in den Figuren mit gleichem Bezugszeichen versehen. Im Folgenden werden ein Kontaktierungselement 1 und eine Steckverbindungseinrichtung 2 für ein Kraftfahrzeug (nicht dargestellt) in gemeinsamer Beschreibung vorgetragen, wobei durch das Kontaktierungselement 1 ein Bestandteil der Steckverbindungseinrichtung 2 darstellt. Die Steckverbindungseinrichtung 2 kann ein Bestandteil des Kraftfahrzeugs bilden. Zudem gehen aus der folgenden Beschreibung die Merkmale eines Baukastensystems zum Herstellen der Steckverbindungseinrichtung 2 hervor.

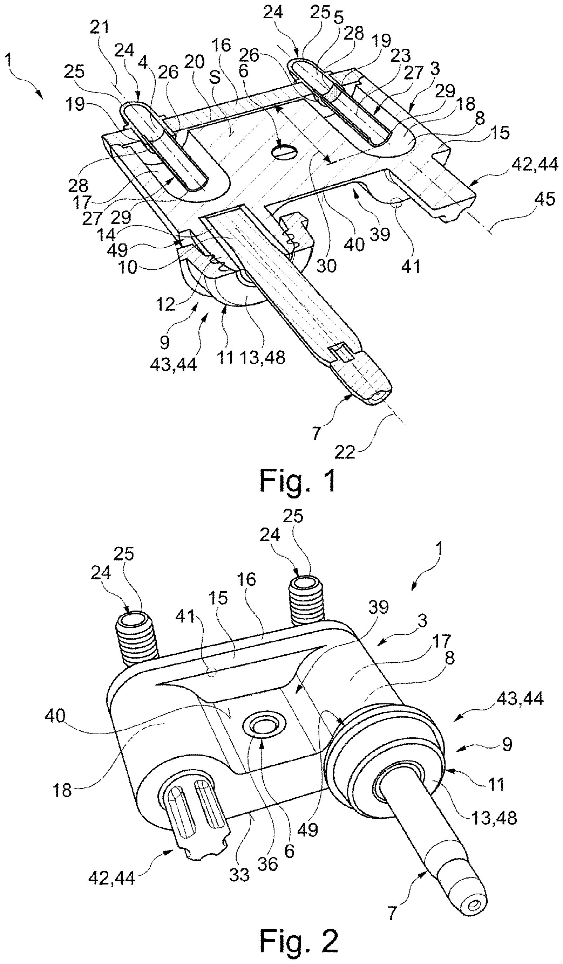

Hier zu zeigen Fig. 1 und Fig. 2 eine perspektivische Ansicht des Kontaktierungselements 1, wobei die Ansicht in Fig. 1 entlang einer Symmetrieebene S des Kontaktierungselements 1 geschnitten ist. Das Kontaktierungselement 1 weist einen Kühlkörper 3, eine Einströmöffnung 4, eine Ausströmöffnung 5, ein erstes Verbindungselement 6 sowie einen Kontaktierungspin 7 auf. Es ist insbesondere vorgesehen, dass das Kontaktierungselement in Bezug auf die Symmetrieebene S symmetrisch ausgeführt ist. Der Kühlkörper 3 des Kontaktierungselements 1 begrenzt eine von einem elektrisch nichtleitenden Kühlmittel (nicht dargestellt) durchströmbare Kühlmittelkammer 8 und ist aus einem elektrisch leitfähigen Material, hier im Beispiel Kupfer, ausgebildet. Der Kühlkörper 3 ist außenseitig und/oder innenseitig mit einer Korrosionsschutzbeschichtung beschichtet. Mittels einer Befestigungseinrichtung 9 des Kontaktierungselements 1, ist der Kontaktierungspin 7 (hier als Vollpin ausgeführt), über dessen Befestigungsabschnitt 10 am Kühlkörper 3 fixiert und gleichzeitig elektrisch leitend mit dem Kühlkörper 3 kontaktiert. Vorliegend weist die Befestigungseinrichtung 9 eine Spanneinheit 11 auf, in dessen Befestigungsabschnittaufnahme 12 der Befestigungsabschnitt 10 des Kontaktierungspins 7 eingesetzt ist. Zu der Spanneinheit 11 gehört zudem eine Überwurfmutter 13, mittels derer die Befestigungsabschnittaufnahme 12 an den Befestigungsabschnitt 10 gespannt ist, sodass zwischen dem Befestigungsabschnitt 10 und der Befestigungsabschnittaufnahme 12 eine kraftschlüssige und elektrisch leitende Verbindung hergestellt ist. Zumindest ein Teil der Befestigungseinrichtung 9, hier die Befestigungsabschnittaufnahme 12, und der Kühlkörper 3 sind einstückig miteinander ausgebildet. Es ist alternativ denkbar, dass der Kontaktierungspin 7 und der Kühlkörper 3 einstückig miteinander ausgebildet sind, sodass durch den Kontaktierungspin 7 ein integraler Bestandteil des Kontaktierungselements 1 gebildet ist. In diesem Fall ist die Befestigungseinrichtung 9 als ein Materialübergangsbereich ausgebildet, in dem das Material des Kühlkörpers 3 und ein Material des Kontaktierungspins 7 nahtlos ineinander übergehen.

Vorliegend weist die Befestigungseinrichtung 9 eine Innengewindehülse 14 auf, deren Innengewinde mit einem Außengewinde des Kontaktierungspins 7 korrespondiert, das an dessen Befestigungsabschnitt 10 angeordnet ist. Dabei bilden die Innengewindehülse 14 und ein Hülsensitz der Befestigungseinrichtung 9 miteinander einen Pressverband. Der Kontaktierungspin 7 ist dann in die den Hülsensitz aufweisende oder bildende Befestigungsabschnittaufnahme 12 eingeschraubt. Zudem ist eine Ausführungsform denkbar bei der der Kontaktierungspin 7 direkt - das heißt ohne Hülse - in den Hülsensitz eingeschraubt oder eingesetzt, insbesondere eingepresst ist. Eine Kombination aus Hülsensitz-Innengewindehülse-Anordnung und Spanneinheit 11 ist genauso gut denkbar. In diesem Fall kann die Innengewindehülse 14 in den Hülsensitz eingeschraubt, eingesetzt und/oder eingepresst und mittels der Überwurfmutter 13 gesichert sein.

Der Kühlkörper 3 ist zum Beispiel mittels eines spanlosen Fertigungsverfahrens und/oder mittels eines spanenden Fertigungsverfahrens hergestellt, wobei es sich bei dem Kühlkörper 3 insbesondere um ein monolithisches Bauteil handeln kann. Im hier erläuterten Beispiel ist der Kühlkörper 3 zweiteilig ausgebildet und umfasst einen Kühlmittelkammeranteil 15 und einen separat davon ausgebildeten Kühlmittelkammerdeckel 16. Diese sind kraft-, form- und/oder stoffschlüssig miteinander verbunden, zum Beispiel verschraubt, vorliegend miteinander verschweißt. Die Kühlmittelkammer 8 ist so - abgesehen von einer Einströmöffnung 4 und einer Ausströmöffnung 5 - von dem Kühlmittelkammeranteil 15 zusammen mit dem Kühlmittelkammerdeckel 16 vollständig umschlossen. Zum Herstellen des Kühlmittelkammeranteils 15 kommt zum Beispiel Kaltfließpressen zum Einsatz.

Die Kühlmittelkammer 8 ist vorliegend in eine Einströmteilkammer 17 und in eine Ausströmteilkammer 18 unterteilt, wobei die Einströmöffnung 4 den Kühlkörper 3 durchdringt und in die Kühlmittelkammer 8 mündet, indem sie den Kühlmittelkammerdeckel 16 durchdringt und so in die Einströmteilkammer 17 mündet. Die Ausströmöffnung 5 durchdringt den Kühlkörper 3 und mündet in die Kühlmittelkammer 8, indem sie den Kühlmittelkammerdeckel 16 durchdringt und so in die Ausströmteilkammer 18 mündet. Ferner ist die Einströmöffnung 4 dazu eingerichtet, außenseitig des Kühlkörpers 3 mit einem Zulaufkanal eines Kühlmittelkreislaufs (nicht dargestellt) der Steckverbindungseinrichtung 2 fluidisch verbunden zu werden. In analoger Weise ist die Ausströmöffnung 5 dazu eingerichtet, außenseitig des Kühlkörpers 3 mit einem Rücklaufkanal des Kühlmittelkreislaufs der Steckverbindungseinrichtung 2 fluidisch verbunden zu werden. Die jeweilige Öffnung 4, 5 weist eine jeweilige eine kühlmittelkammerseitige Mündung 19 auf, über welche die entsprechende Öffnung 4, 5 in die Kühlmittelkammer 8, das heißt in die entsprechende der Teilkammern 17,18, mündet. In Abweichung von den Fig. kann vorgesehen sein, dass die Öffnungen 4, 5 an jeweils unterschiedlichen Gehäusewänden des Kühlkörper 3 ausgebildet sind. Zum Beispiel kann die Einströmöffnung 4 den Kühlmittelkammerdeckel 16 durchdringen, wohingegen die Ausströmöffnung 5 den Kühlmittelkammeranteil 15 durchdringen kann.

Die beiden Teilkammern 17, 18 sind miteinander fluidisch verbunden, vorliegend mittels eines Verbindungskanals 20. Dieser ist im Vergleich mit den Teilkammern 17, 18 schmal ausgeführt und wird im vorliegenden Beispiel zum einen durch den Kühlmittelkammeranteil 15 und zum anderen durch den Kühlmittelkammerdeckel 16 begrenzt. Das bedeutet, das eine Gesamtkanalinnenwand des Verbindungskanals 20 durch eine Innenwand des Kühlmittelkammeranteils 15 und eine Innenwand des Kühlmittelkammerdeckels 16 gebildet ist. Die beiden Teilkammern 17, 18 sind voneinander beabstandet, was bedeutet, dass eine Längsmittenachse 21 der Einströmteilkammer 17 und eine Längsmittenachse 22 des Kontaktierungspins 7 zusammenfallen, wobei eine Längsmittenachse 23 der Ausströmteilkammer 18 und die Längsmittenachse 21 der Einströmteilkammer 17 - vorliegend parallel - auseinanderfallen.

Des Weiteren weist das Kontaktierungselement 1 - vorliegende je Öffnung 4, 5 - ein Kanalkopplungselement 24 auf, dessen jeweiliges erstes Ende 25 sich beispielsweise außenseitig der Kühlmittelkammer 8 fluidisch an die entsprechende Öffnung 4, 5 anschließt. Vorliegend ist das jeweilige erste Ende 25 des jeweiligen Kanalkopplungselements 24 in die entsprechende Öffnung 4, 5 passend eingesetzt. Jedenfalls ist ein jeweiliges zweites Ende 26 des jeweiligen Kanalkopplungselements 24 dazu eingerichtet, mit dem entsprechenden Kanal - das heißt mit dem Zulaufkanal bzw. mit dem Rücklaufkanal - des Kühlmittelkreislaufs fluidisch verbunden zu werden. Es ist zu erkennen, dass das jeweilige erste Ende 25 in der Kühlmittelkammer 8 die jeweilige kühlmittelkammerseitige Mündung 19 überragt bzw. von der jeweiligen kühlmittelkammerseitigen Mündung 19 nach innen hervorspringt.

Fig. 1 zeigt weiter, dass an der Einströmöffnung 4 oder an der Ausströmöffnung 5, hier im Beispiel an der Einströmöffnung 4 und an der Ausströmöffnung 5, jeweils eine mit dem Kühlmittel durchströmbare längliche Kühlmittellanze 27 angeordnet ist. Eine jeweilige erste Lanzenmündung 28 der Kühlmittellanzen 27 ist fluidisch mit der jeweiligen kühlmittelkammerseitigen Mündung 19 verbunden. Eine jeweilige zweite Lanzenmündung 29 der Kühlmittellanzen 27 ist über eine freie Lanzenlänge 30 von der kühlmittelkammerseitigen Mündung 19 der jeweiligen Öffnung 4, 5 beabstandet, sodass die jeweilige Kühlmittellanze 27 in die Kühlmittelkammer 8, das heißt in die entsprechende Teilkammer 17, 18 hineinragt.

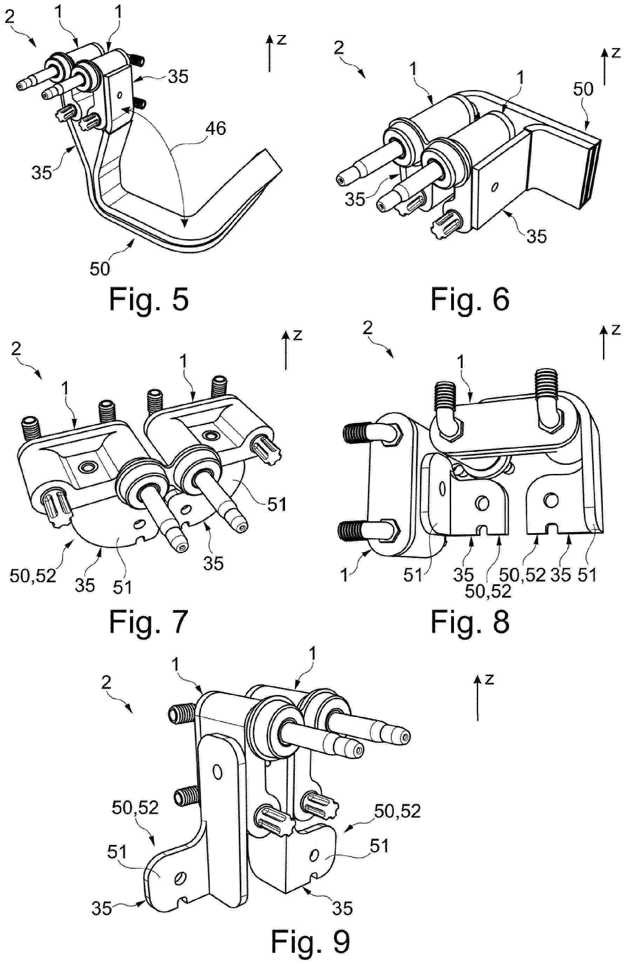

Das erste Verbindungselement 6 ist dazu eingerichtet, mit einem korrespondierenden, zweiten Verbindungselement 31 (siehe Fig. 5) der Steckverbindungseinrichtung 2 eine flächige kraft-, form- und/oder stoffschlüssige sowie elektrisch leitende und wärmeleitende Verbindungsvorrichtung 32 zwischen einer Kontaktierungsfläche 33 des Kühlkörpers 3 und einer korrespondierenden Kontaktierungsfläche 34 einer Stromschiene 35 der Steckverbindungseinrichtung 2 zu bilden. Bei der Steckverbindungseinrichtung 2 liegen die miteinander korrespondierenden Kontaktierungsflächen 33, 34 und infolgedessen das Kontaktierungselement 1 und die entsprechende Stromschiene 35 aneinander an. Hier im Beispiel sind die Kontaktierungsflächen 33, 34 mittels einer Schraube (nicht dargestellt bzw. in den Fig. durch andere Zeichnungsobjekte verdeckt) aneinandergespannt. Hierzu weist das erste Verbindungselement 6 eine Innengewindeöffnung auf, zum Beispiel ein in das Material des Kühlkörpers 3 geformtes/geschnittenes Innengewinde. Vorliegend weist das erste Verbindungselement 6 eine Gewindehülse oder-buchse 36 auf, die in einen korrespondierenden Hülsen- bzw. Buchsensitz des Kühlkörpers 3 eingesetzt ist. Die Gewindehülse 36 ist beispielsweise in den Hülsensitz, das heißt in den Kühlkörper 3, eingepresst. Das zweite Verbindungselement 31 weist eine mit dem Schraubbolzen korrespondierende Schraubbolzenöffnung 37 (siehe Fig. 5) auf. Ein Bolzenanteil der Schraube ist bei der Steckverbindungseinrichtung 2 einerseits in die Innengewindeöffnung, vorliegend also in die Gewindehülse 36, des Kühlkörpers 3 bzw. in das erste Verbindungselement 6 eingeschraubt und ragt andererseits durch die Schraubbolzenöffnung 37 hindurch und dadurch über eine von der Kontaktierungsfläche 34 abgewandten Fläche 38 der Stromschiene 35 über diese hinaus. Unter vermittelter Gewindeverbindung zwischen dem Bolzenanteil der Schraube und dem Innengewinde sind die Stromschiene 35 und der Kühlkörper 3 bei angezogener/festgezogener Schraube aneinandergespannt, wobei die Stromschiene 35 zwischen dem Kühlkörper 3 und einem Schraubenkopf der Schraube eingespannt ist. Dadurch sind die Kontaktierungsflächen, 33, 34 aneinandergespannt, wodurch die Stromschiene 35 und das Kontaktierungselement 1 aneinandergespannt sind, wodurch die Stromschiene 35 und das Kontaktierungselement 1 elektrisch und wärmeleitend miteinander verbunden sind. Obwohl die Schraube hier im Beispiel als Bestandteil der zweiten Verbindungsvorrichtung 32 beschrieben ist, kann sie in alternativer Ausführung der Steckverbindungseinrichtung 2 dem ersten Verbindungselement 6 zugerechnet werden. Alternativ oder zusätzlich kann zwischen den Kontaktierungsflächen 33, 34 eine Schweißverbindung ausgebildet sein, die zum Beispiel mittels Reib-, Ultraschall- und/oder Laserschweißens erzeugt ist. Es kommt weiter in Frage - insbesondere ergänzend zu der beschriebenen oder einer anderen Schraubverbindung -, zwischen den Kontaktierungsflächen 33, 34 einen elektrisch leitfähigen Klebstoff, insbesondere eine Wärmeleitpaste, zu applizieren, sodass die Kontaktierungsflächen 33, 34 mittels einer Klebeverbindung aneinander befestigt sind.

Vorliegend weist das erste Verbindungselement 6 eine Senke bzw. Mulde 39 auf, die dazu eingerichtet ist, bei der Steckverbindungseinrichtung 2 einen Teil der Verbindungsvorrichtung 32, zum Beispiel das erste Verbindungselement 6 und/oder das zweite Verbindungselement 31 bzw. wenigstens einen jeweiligen Teil desselben, derart aufzunehmen, dass die Verbindungsvorrichtung 32 an einer Fläche 40, die von der Kontaktierungsfläche 33 des Kühlkörpers 3 abgewandt ist, vollständig in eine vorgegebene Außenkontur 41 eintaucht bzw. nicht über die Außenkontur 41 übersteht oder nicht von dieser hervorspringt. Vorliegend ist vorgesehen, dass der Schraubenkopf eine axiale Länge aufweist, die maximal so lang ist, wie die Senke 39 ausgehend von der Außenkontur 41 tief ist, sodass der Schraubenkopf bei der Steckverbindungseinrichtung 2 nicht über die Außenkontur 41 hinausragt. Sofern die Gewindehülse 36 eingesetzt wird, schließt deren Hülsenrand mit der Kontaktierungsfläche 33 bündig ab, und ein zweiter Hülsenrand ragt allenfalls in die Senke 39 hinein, überragt aber nicht die Außenkontur 41. Wie aus Fig. 1 und Fig. 2 weiter hervorgeht, taucht die Senke 39 zwischen den Teilkammern 17, 18 der Kühlmittelkammer 8 ausgehend von der Außenkontur 41 in den Kühlkörper 3 ein. Dabei wird im Inneren des Kühlkörpers 3 (siehe geschnittene Ansichten der Fig.) eine Breite der Senke 39 von dem Verbindungskanal 20 überspannt.

Fig. 1 und Fig. 2 zeigen weiter, dass das Kontaktierungselement 1 hier im Beispiel ein erstes Fixierungselement 42 aufweist, das mit einem zweiten Fixierungselement (nicht dargestellt) der Steckverbindungseinrichtung 2 oder des Kraftfahrzeugs zum Bilden einer Fixierungseinrichtung (nicht dargestellt) korrespondiert, mittels derer das Kontaktierungselement 1 positionell fixiert bzw. gesichert ist. Das erste Fixierungselement 42 ist beispielsweise als ein Fixierungszapfen ausgeführt und das zweite Fixierungselement als eine Zapfenaufnahme, in die der Fixierungszapfen bei der Steckverbindungseinrichtung 2 eingesetzt ist. Ferner kann das erste Fixierungselement 42 einen Schraubstehbolzen aufweisen, der von dem Kühlkörper 3 hervorspringt, durch eine entsprechend zugeordnete Schraubbolzenöffnung - eines Trägerelements (nicht dargestellt) des Kraftfahrzeugs oder der Steckverbindungseinrichtung 2 - hindurchragt und mit einer Schraubmutter gegen ein Herausbewegen aus der Schraubbolzenöffnung gesichert ist. Durch das Trägerelement erstreckt sich insbesondere der Kontaktierungspin 7 bzw. dessen Befestigungseinrichtung 9 hindurch, wobei die Befestigungseinrichtung 9 bzw. der Kontaktierungspin 7 in einem Fixierungsabschnitt 43 analog zu dem ersten Fixierungselement 42 ausgeführt sein kann. Das Kontaktierungselement 1 weist also hier zwei analog ausgebildete Fixierungskörper 44 auf - nämlich einen, der durch das erste Fixierungselement 42 gebildet ist, und einen anderen, der durch den Fixierungsabschnitt 43 gebildet ist. Dementsprechend ist vorgesehen, dass die Steckverbindungseinrichtung 2 eine mit dem Fixierungsabschnitt 43 korrespondiere Fixierungsabschnittaufnahme (nicht dargestellt) aufweist. Mittels der Fixierungseinrichtung, die zumindest das erste Fixierungselement 42, vorliegend zusätzlich den Fixierungsabschnitt 43, aufweist, ist das Kontaktierungselement 1 positionell gesichert, beispielsweise an dem Trägerelement. Dabei sind erste Fixierungselement 42 und der Fixierungsabschnitt 43 über einen Hebelabstand voneinander beabstandet, der so vorgegeben ist, dass zu erwartende Kipp- und/oder Drehmomente besonders effizient über die Fixierungseinrichtung aufgenommen werden können. Eine Längsmittenachse 45 des ersten Fixierungselements 42 und die Längsmittenachse 23 der Ausströmteilkammer 18 fallen vorliegend zusammen.

In einem Betrieb des Kontaktierungselements 1 bzw. der Steckverbindungseinrichtung 2 fungieren der Kühlkörper 3 - das heißt der Kühlmittelkammeranteil 15 und der Kühlmittelkammerdeckel 16 die Stromschiene 35 sowie der Kontaktierungspin 7 als stromführende Elemente. Bei dem Betrieb handelt es sich zum Beispiel um einen Ladebetrieb einer Traktionsbatterie eines ganz oder teilweise elektrisch antreibbaren Kraftfahrzeugs. Im Betrieb wird mittels des Kühlmittelkreislaufs das Kühlmittel angetrieben, das dadurch durch ein Kühlmittelkanalwerk des Kühlmittelkreislaufs getrieben wird. Da der Zulaufkanal des Kühlmittelkreislaufs fluidisch mit der Einströmöffnung 4 verbunden ist (vorliegend mittels des in die Einströmöffnung 4 eingesetzten Kanalkopplungselements 24) wird das Kühlmittel durch das Kanalkopplungselement 24, durch die Einströmöffnung 4, durch die einströmöffnungsseitige Kühlmittellanze 27 und infolgedessen in die Kühlmittelkammer 8 hineingepumpt. Dort streicht/strömt das Kühlmittel innenseitig an dem Kühlkörper 3 entlang und nimmt dabei Wärme auf, die durch einen elektrischen Strom, der im Betrieb durch die Stromschiene 35 bzw. den Kühlmittelkammerdeckel 16 und/oder den Kühlmittelkammeranteil 15 und/oder den Kontaktierungspin 7 fließt, auf. Das so erwärmte Kühlmittel strömt dann durch die Ausströmöffnung 5, vorliegend mittels des in die Ausströmöffnung 5 eingesetzten Kanalkopplungselements 24, in den Rücklaufkanal des Kühlmittelkreislaufs, wodurch die Wärme abtransportiert wird und dementsprechend der Stromschiene 35, der Kühlkörper 3 und der Kontaktierungspin 7 gekühlt werden. So kommt es in den genannten stromführenden Bauteilen im Betrieb nicht oder nur in stark verringertem Maße zu einer wärmeinduzierten Erhöhung des ohmschen Widerstands, wodurch höhere Ladeleistungen dargestellt werden können.

In einem Betrieb des Kontaktierungselements 1 bzw. der das Kontaktierungselement 1 aufweisenden Steckverbindungseinrichtung 2 fungieren der Kühlkörper 3, der damit verbundene und elektrisch kontaktierte Kontaktierungspin 7 sowie der Stromschiene 35 als stromführende Elemente. Bei dem Betrieb handelt es sich zum Beispiel um einen Ladebetrieb einer Traktionsbatterie eines ganz oder teilweise elektrisch antreibbaren Kraftfahrzeugs. Im Betrieb wird mittels des Kühlmittelkreislaufs das Kühlmittel angetrieben, das dadurch durch ein Kühlmittelkanalwerk getrieben wird. Da der Zulaufkanal des Kühlmittelkreislaufs fluidisch mit der Einströmöffnung 4 verbunden ist (vorliegend mittels des in die Einströmöffnung 4 eingesetzten Kanalkopplungselements 24) wird das Kühlmittel durch das Kanalkopplungselement 24, durch die Einströmöffnung 4 und infolgedessen in die Kühlmittelkammer 8 - vorliegend in die Einströmteilkammer 17 - hineingepumpt (hier durch die an der Einströmöffnung 4 angeschlossene der Kühlmittellanzen 27). Dort streicht/strömt das Kühlmittel an dem Kühlkörper 3 entlang und nimmt dabei Wärme auf, die durch einen elektrischen Strom, der im Betrieb durch die Stromschiene 35 und/oder den Kühlkörper 3 und/oder den Kontaktierungspin 7 fließt, auftritt. Das so erwärmte Kühlmittel strömt dann über den Verbindungskanal 20 in die Ausströmteilkammer 18, in die ausströmöffnungsseitige Kühlmittellanze und dann aus der Ausströmöffnung 5 (vorliegend mittels des in die Ausströmöffnung 5 eingesetzten Kanalkopplungselements 24) in den Rücklaufkanal. Das in dem Kontaktierungselement 1 strömende Kühlmittel kühlt also im Betrieb den Kontaktierungspin 7, die Stromschiene 35 sowie den Kühlkörper 3. So kommt es in den genannten stromführenden Bauteilen im Betrieb nicht oder nur in stark verringertem Maße zu einer wärmeinduzierten Erhöhung des ohmschen Widerstands, wodurch höhere Ladeleistungen dargestellt werden können.

Außenseitig weist der Kühlkörper 3 insbesondere einen Sensorsitz (nicht dargestellt) auf, in welchen ein Sensorkopf eines Temperatursensors einer Temperaturmesseinrichtung (nicht dargestellt) eingesetzt ist. Mittels des Temperatursensors wird im Betrieb eine Temperatur des Kontaktierungselements 1 gemessen. Der Sensorsitz ist beispielsweise als ein Sackloch ausgebildet, das insbesondere zusammen mit der Befestigungseinrichtung 9 oder dem Kontaktierungspin 7 an einer gemeinsamen Fläche des Kühlkörpers 3, etwa am Kühlmittelkammeranteil 15 angeordnet ist. Mit anderen Worten ist das Sackloch bzw. der Sensorsitz an derselben Fläche des Kühlkörpers 3 bzw. des Kontaktierungselements 1 angeordnet, von der auch die Befestigungseinrichtung 9 oder der Kontaktierungspin 7 hervorspringt. Der Sensorkopf kann kraft-, form- und/oder stoffschlüssig im Sensorsitz bzw. Sackloch fixiert sein.

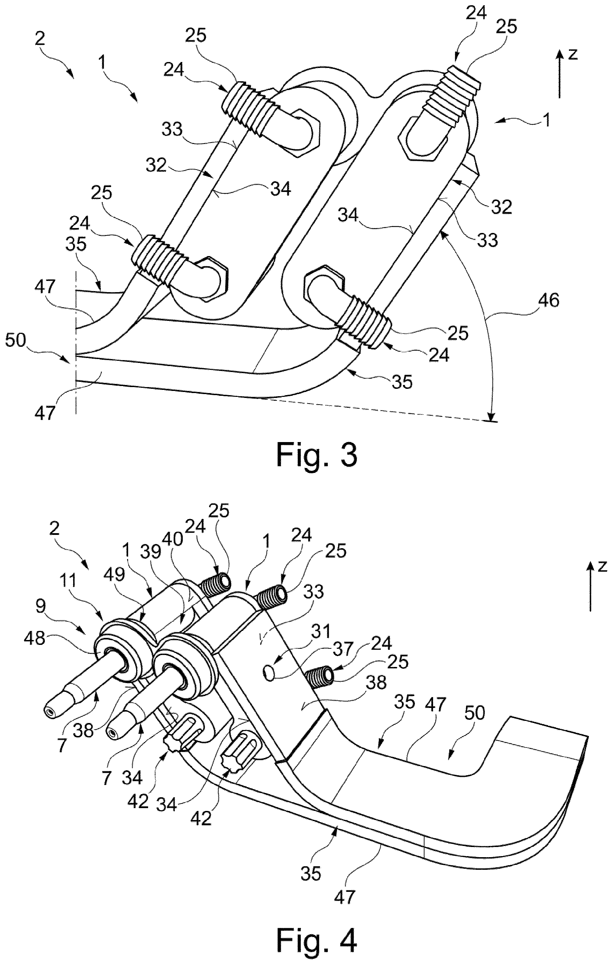

Fig. 3 und Fig. 4 zeigen jeweils eine perspektivische Ansicht der Steckverbindungseinrichtung 2 für das Kraftfahrzeug, wobei die Stromschiene 35 in Verlängerung und das Kontaktierungselement 1 miteinander einen vorgegebenen Einbaulagewinkel 46 einschließen, der von 0° und 180° unterschiedlich ist, das heißt größer als 0° und kleiner als 180° ist. Die Steckverbindungseinrichtung 2 weist zum Herstellen einer elektrisch leitfähigen Steckverbindung zwischen einer elektrischen Energiequelle, zum Beispiel einem infrastrukturellen Stromversorgungsnetz, und einer elektrischen Batterie, beispielsweise einer Traktionsbatterie des Kraftfahrzeugs, zwei Kontaktierungselemente 1 sowie zwei Stromschiene 35 auf. Die Kontaktierungselemente 1 sind vorliegend als Gleichteile ausgebildet. Zudem können die Stromschienen 35 als Gleichteile ausgebildet sein. Aus Fig. 3 geht weiter hervor, dass die jeweilige Stromschiene 35 abseits der jeweiligen Kontaktierungsfläche 34 einen Isolierungsmantel 47 aufweist, wohingegen die Stromschienen 35 zumindest an den Kontaktierungsflächen 34 blank sind. Es kann bei dem jeweiligen Kontaktierungselement 1 generell vorgesehen sein, dass es - abgesehen von dessen Kontaktierungsfläche 33 - einen Isolierungsmantel aufweist; jedenfalls ist die Kontaktierungsfläche 33 frei von einem Isolationsmaterial. Da die Kontaktierungsflächen 33, 34 unisoliert bzw. blank sind, vermitteln sie eine elektrisch leitende Verbindung, sobald/solang sie sich berühren. Die Steckverbindungseinrichtung 2 weist zudem zwei Verbindungsvorrichtungen 32 auf, mittels derer das jeweilige Kontaktierungselement 1 an die entsprechend zugeordnete der Stromschienen 35 elektrisch und wärmeleitend angebunden ist. Dabei sind die Stromschienen 35 und die Kontaktierungselemente 1 voneinander elektrisch isoliert. Mittels des Kühlmittelkreislaufs sind sowohl die Kontaktierungselemente als auch die Stromschienen 35 kühlbar bzw. entwärmbar, indem die jeweilige Einströmöffnung 4 mit dem Zulaufkanal des Kühlmittelkreislaufs fluidisch verbunden ist und die jeweilige Ausströmöffnung 5 mit einem Rücklaufkanal des Kühlmittelkreislaufs fluidisch verbunden ist. Dabei sind die beiden Kontaktierungselemente 1 gemäß Fig. 3 so angeordnet, dass die Senken 39 einander zugewandt sind. Mit anderen Worten sind die Flächen 40 einander zugewandt, wobei die Kontaktierungsflächen 33 voneinander abgewandt sind.

Die Steckverbindungseinrichtung 2 weist ein Gehäuse (nicht dargestellt) auf, das eine erste Gehäusekammer für eines der Kontaktierungselemente 1 und eine zweite Gehäusekammer für das entsprechend andere der Kontaktierungselemente 1 aufweist. Dabei weist das Gehäuse eine Abstützeinrichtung auf, mittels derer die Kontaktierungselemente 1 positionsfest abgestützt sind, sodass die Abstützeinrichtung im Betrieb auf die Kontaktierungselemente 1 einwirkende Positionsänderungskräfte aufnimmt. Das Gehäuse weist eine offene Gehäuseseite auf, durch welche hindurch die Kontaktierungselemente 1 samt zugehöriger Stromschienen 35 Gehäusekammern eingeschoben sind. Das Gehäuse ist ferner aus einem elektrisch isolierenden bzw. elektrisch nichtleitenden Material dazu ausgebildet, die Kontaktierungselemente 1 voneinander elektrisch zu trennen bzw. zu isolieren.

Zudem ist am Gehäuse eine Taumelstütze vorgesehen, die vorliegend ein Überwurfelement 48 aufweist, bei dem es sich vorliegend um die Überwurfmutter 13 handelt (vgl. Fig. 1 und Fig. 2) oder um ein anderes Überwurfelement 48 (vgl. Fig. 3 und Fig. 4), beispielsweise um eine (insbesondere gewindelose) Überwurfhülse, die auf einen korrespondierenden Überwurfhülsensitz aufgepresst ist. Jedenfalls erstrecken die Kontaktierungspins 7 sich durch das Überwurfelement 48 hindurch, wobei das Überwurfelement 48 am jeweiligen Kontaktierungspin 7 befestigt ist. Bei der Steckverbindungseinrichtung 2 können die Überwurfelemente 48 für die Kontaktierungspins 7 miteinander verbunden sein bzw. ineinander übergehen oder einstückig miteinander ausgebildet sein. Das Gehäuse der Steckverbindungseinrichtung 2 verläuft zwischen dem Überwurfelement 13, 48, sodass die Kontaktierungspins 7 an das Gehäuse angespannt sind. In Fig. 1, Fig. 2 und Fig. 4 ist ein Spalt 49 dargestellt, durch welchen das Gehäuse, das heißt eine Gehäusewand desselben, hindurchverläuft.

Die Durch Packaging-Vorgaben und/oder angesichts einer Gesamtarchitektur als Randbedingung für den Einsatz der Steckverbindungseinrichtung 2 sind

Das Baukastensystem zum Herstellen der Steckverbindungseinrichtung 2 umfasst eine einzige Kontaktierungselementvariante, die gemäß dem Kontaktierungselement 1 ausgebildet ist. Vorliegend umfasst das Baukastensystem zumindest noch unterschiedliche Varianten von Stromschienen 35 sodass eine Vielzahl unterschiedliche Steckverbindungseinrichtungen 2 bzw. Steckverbindungseinrichtungsvarianten mithilfe des Baukastensystems hergestellt werden können. In Fig. 3 und Fig. 4 ist eine Variante der Steckverbindungseinrichtung 2 dargestellt, bei der der Einbaulagewinkel zum Beispiel 60° beträgt. Mit Blick auf Fig. 3 wird deutlich, dass für die Stromschienen 35 dieselbe Stromschienenvariante zum Einsatz kommen kann. Unterschiedliche Gehäusevarianten und/oder unterschiedliche Stromschienenvarianten sind denkbar.

In Fig. 5 bis Fig. 9 ist jeweils in perspektivischer Ansicht jeweils eine weitere Variante der Steckverbindungseinrichtung 2 gezeigt. Fig. 5 zeigt eine Steckverbindungseinrichtungsvariante, bei der der Einbaulagewinkel zwischen der jeweiligen Verlängerung 50 der Stromschiene und dem Kontaktierungselement 90° beträgt. Dabei sind die Kontaktierungselemente 1 parallel zueinander angeordnet, und eine jeweilige Längsmittenfaser der Stromschienen 35 verläuft quer zu den Kontaktierungselementen 1. Fig. 6 zeigt eine Steckverbindungseinrichtungsvariante, bei der der Einbaulagewinkel zwischen der jeweiligen Verlängerung 50 der Stromschiene und dem Kontaktierungselement 90° beträgt. Dabei sind die Kontaktierungselemente 1 parallel zueinander angeordnet, und die jeweilige Längsmittenfaser der Stromschienen 35 verläuft längs zu den Kontaktierungselementen 1. Im Fall der Fig. 5 und/oder im Fall der Fig. 6 können die Stromschienen 35 derselben Stromschienenvariante entstammen.

Fig. 7 zeigt eine weitere Steckverbindungseinrichtungsvariante, bei der die jeweilige Stromschiene 35 einen Stromschienenhauptkörper (nicht dargestellt) und einen separat davon hergestellten Stromschienenadapterkörper 51 aufweist, wobei der Stromschienenhauptkörper und das Kontaktierungselement 1 mittels des Stromschienenadapterkörpers 51 elektrisch aneinander angeschlossen sind. Hierzu sind der Stromschienenadapterkörper 51 und der Stromschienenhauptkörper miteinander verbunden, wodurch die Stromschiene 35 gebildet ist. Gemäß Fig. 7 sind die Stromschienenadapterkörper 51 als Gleichteile ausgebildet. Der Einbaulagewinkel 46 beträgt in diesem Fall 90°, wobei die Verlängerung 50 der Stromschiene 35 ein Fortsatz 52 des Stromschienenadapterkörpers 51 ist. Unterschiedlich ausgebildete Stromschienenadapterkörper 51 können bei der Steckverbindungseinrichtung 2 ebenso zum Einsatz kommen, wie Fig. 8 zeigt. Die Fortsätze 52 der Stromschienenadapterkörper 51 schließen mit den Kontaktierungselementen 1 jeweils einen Einbaulagewinkel von 90° ein, wobei die Kontaktierungselemente 1 dabei miteinander selbst einen Winkel von 90° einschließen. Fig. 9 zeigt eine weitere Steckverbindungseinrichtungsvariante, bei der die Kontaktierungselemente 1 gleichgerichtet aufgereiht sind. Dabei kommen zwei als Gleichteil ausgebildete Stromschienenadapterkörper 51 zum Einsatz, und die jeweilige Längsmittenfaser der Stromschienen 35, hier der Stromschienenadapterkörper 51, verläuft quer zu den Kontaktierungselementen 1.

### BEZUGSZEICHENLISTE

- 1: Kontaktierungselement
- 2: Steckverbindungseinrichtung
- 3: Kühlkörper
- 4: Einströmöffnung
- 5: Ausströmöffnung
- 6: erstes Verbindungselement
- 7: Kontaktierungspin
- 8: Kühlmittelkammer
- 9: Befestigungseinrichtung
- 10: Befestigungsabschnitt
- 11: Spanneinheit
- 12: Befestigungsabschnittaufnahme
- 13: Überwurfmutter
- 14: Innengewindehülse
- 15: Kühlmittelkammeranteil
- 16: Kühlmittelkammerdeckel
- 17: Einströmteilkammer
- 18: Ausströmteilkammer
- 19: kühlmittelkammerseitige Mündung
- 20: Verbindungskanal
- 21: Längsmittenachse der Einströmteilkammer
- 22: Längsmittenachse eines Kontaktierungspins
- 23: Längsmittenachse der Ausströmteilkammer
- 24: Kanalkopplungselement
- 25: erstes Ende des Kanalkopplungselements
- 26: zweites Ende des Kanalkopplungselements
- 27: Kühlmittellanze
- 28: erste Lanzenmündung
- 29: zweite Lanzenmündung
- 30: freie Lanzenlänge
- 31: zweites Verbindungselement
- 32: Verbindungsvorrichtung
- 33: Kontaktierungsfläche des Kühlkörpers
- 34: Kontaktierungsfläche der Stromschiene
- 35: Stromschiene
- 36: Gewindehülse/Gewindebuchse
- 37: Schraubbolzenöffnung
- 38: der Kontaktierungsfläche entgegengesetzte Fläche der Stromschiene
- 39: Senke/Mulde
- 40: der Kontaktierungsfläche entgegengesetzte Fläche des Kühlkörpers
- 41: Außenkontur
- 42: Fixierungselement
- 43: Fixierungsabschnitt des Kontaktierungspins bzw. der Befestigungseinrichtung
- 44: Fixierungskörper
- 45: Längsmittenachse des ersten Fixierungselements
- 46: Einbaulagewinkel
- 47: Isolierungsmantel
- 48: Überwurfelement
- 49: Spalt
- 50: Verlängerung
- 51: Stromschienenadapterkörper
- 52: Fortsatz

- S: Symmetrieebene

## Patentansprüche

1. Kontaktierungselement (1) für eine Steckverbindungseinrichtung (2) für ein Kraftfahrzeug, mittels derer eine elektrisch leitfähige Steckverbindung herstellbar ist, wobei das Kontaktierungselement (1) aufweist:
- einen Kühlkörper (3), der
- eine mit einem elektrisch nichtleitenden Kühlmittel durchströmbare Kühlmittelkammer (8) begrenzt,
- aus einem elektrisch leitfähigen Material ausgebildet ist,
- einen Kühlmittelkammeranteil (15) und einen Kühlmittelkammerdeckel (16) aufweist, die miteinander verbunden sind,
- eine Einströmöffnung (4), die den Kühlmittelkammerdeckel (16) durchdringt, in die Kühlmittelkammer (8) mündet und dazu eingerichtet ist, außenseitig des Kühlkörpers (3) mit einem Zulaufkanal eines Kühlmittelkreislaufs fluidisch verbunden zu werden,
- eine von der Einströmöffnung (4) separat ausgebildete Ausströmöffnung (5), die den Kühlmittelkammerdeckel (16) durchdringt, in die Kühlmittelkammer (8) mündet und dazu eingerichtet ist, außenseitig des Kühlkörpers (3) mit einem Rücklaufkanal des Kühlmittelkreislaufs fluidisch verbunden zu werden,
- ein erstes Verbindungselement (6), das dazu eingerichtet ist, mit einem korrespondierenden, zweiten Verbindungselement (31) der Steckverbindungseinrichtung (2) eine flächige elektrisch leitende und wärmeleitende Verbindungsvorrichtung (32) zwischen einer Kontaktierungsfläche (33) des Kühlkörpers (3) und einer korrespondierenden Kontaktierungsfläche (34) einer Stromschiene (35) zu bilden.

2. Kontaktierungselement (1) nach Anspruch 1,
**dadurch gekennzeichnet, dass**
das erste Verbindungselement (6) eine Senke (39) aufweist, die dazu eingerichtet ist, einen Teil der Verbindungsvorrichtung (32) derart aufzunehmen, dass die Verbindungsvorrichtung (32) an einer Fläche (40), die von der Kontaktierungsfläche (33) des Kühlkörpers (3) abgewandt ist, vollständig in eine vorgegebene Außenkontur (41) eintaucht.

3. Kontaktierungselement (1) nach Anspruch 1 oder 2,
**dadurch gekennzeichnet, dass**
die Kühlmittelkammer (8) eine Einströmteilkammer (17), eine von der Einströmteilkammer (17) beabstandete Ausströmteilkammer (18) und einen verglichen mit den Teilkammern (17, 18) schmalen Verbindungskanal (20) aufweist, wobei die Einströmteilkammer (17) und die Ausströmteilkammer (18) mittels des Verbindungskanals (20) fluidisch miteinander verbunden sind.

4. Kontaktierungselement (1) nach Anspruch 2 und 3,
**dadurch gekennzeichnet, dass**
die Senke (39) zwischen der Einströmteilkammer (17) und der Ausströmteilkammer (18) in den Kühlkörper (3) eintaucht.

5. Kontaktierungselement (1) nach den Ansprüchen 2 und 3 oder nach Anspruch 3 oder 4,
**dadurch gekennzeichnet, dass**
eine Längsmittenachse (21) der Einströmteilkammer (17) und eine Längsmittenachse (22) eines Kontaktierungspins (7) des Kontaktierungselements (1) zusammenfallen, wobei eine Längsmittenachse (23) der Ausströmteilkammer (18) und die Längsmittenachse (21) der Einströmteilkammer (17) auseinanderfallen.

6. Kontaktierungselement (1) nach einem der vorhergehenden Ansprüche,
**dadurch gekennzeichnet, dass**
der Verbindungskanal (20) zum einen durch den Kühlmittelkammeranteil (15) und zum anderen durch den Kühlmittelkammerdeckel (16) begrenzt ist.

7. Kontaktierungselement (1) nach einem der vorhergehenden Ansprüche,
**dadurch gekennzeichnet, dass**
an der Einströmöffnung (4) und/oder an der Ausströmöffnung (5) eine sich in die Kühlmittelkammer (8) hineinerstreckende längliche Kühlmittellanze (27) des Kontaktierungselements (1) angeordnet ist, die mit dem Kühlmittel durchströmbar ist und deren erste Lanzenmündung (28) fluidisch mit einer kühlmittelkammerseitigen Mündung (19) der entsprechenden Öffnung (4, 5) verbunden ist, wobei eine zweite Lanzenmündung (29) der Kühlmittellanze (27) und die kühlmittelkammerseitige Mündung (19) über eine freie Lanzenlänge (30) voneinander beabstandet sind.

8. Kontaktierungselement (1) nach einem der vorhergehenden Ansprüche,
**gekennzeichnet durch**
ein erstes Fixierungselement (42), das mit einem zweiten Fixierungselement der Steckverbindungseinrichtung (2) oder des Kraftfahrzeugs zum Bilden einer Fixierungseinrichtung korrespondiert, mittels derer das Kontaktierungselement (1) positionell fixierbar ist.

9. Kontaktierungselement (1) nach den Ansprüchen 3 und 8, oder einem der Ansprüche 2 oder 4 bis 7 in Rückbezug auf die Ansprüche 3 und 8
**dadurch gekennzeichnet, dass**
eine Längsmittenachse (45) des ersten Fixierungselements (42) und die Längsmittenachse (23) der Ausströmteilkammer (18) zusammenfallen.

10. Steckverbindungseinrichtung (2) für ein Kraftfahrzeug, mittels derer eine elektrisch leitfähige Steckverbindung zwischen einer elektrischen Energiequelle und einer elektrischen Batterie herstellbar ist, wobei die Steckverbindungseinrichtung (2) aufweist:
- als ein erstes Kontaktierungselement das nach einem oder mehr der Ansprüche 1 bis 9 ausgebildete Kontaktierungselement (1), dessen Kontaktierungsfläche (33) und die korrespondierenden Kontaktierungsfläche (34) einer Stromschiene (35) der Steckverbindungseinrichtung (2) mittels der Verbindungsvorrichtung (32) elektrisch und wärmeleitend verbunden ist,
- ein weiteres Kontaktierungselement, das mit einer weiteren Stromschiene (35) der Steckverbindungseinrichtung (2) elektrisch verbunden ist,
- einen mit einem Kühlmittel durchströmbaren Kühlmittelkreislauf,
wobei das erste Kontaktierungselement (1) und die Stromschiene (35) mittels des Kühlmittelkreislaufs kühlbar ist, indem die Einströmöffnung (4) mit einem Zulaufkanal des Kühlmittelkreislaufs fluidisch verbunden ist und die Ausströmöffnung (5) mit einem Rücklaufkanal des Kühlmittelkreislaufs fluidisch verbunden ist.

11. Steckverbindungseinrichtung (2) nach Anspruch 10,
**dadurch gekennzeichnet, dass**
eine oder beide der Stromschienen (35) einen Stromschienenhauptkörper und einen Stromschienenadapterkörper (51) aufweist/aufweisen, wobei der Stromschienenhauptkörper und das erste Kontaktierungselement (1) mittels des Stromschienenadapterkörpers (51) elektrisch aneinander angeschlossen sind.

12. Steckverbindungseinrichtung (2) nach Anspruch 11,
**dadurch gekennzeichnet, dass**
beide der Stromschienen (35) jeweils einen Stromschienenadapterkörper (51) aufweisen, und die Stromschienenadapterkörper (51) als Gleichteile ausgebildet sind.

13. Steckverbindungseinrichtung (2) nach einem der Ansprüche 10 bis 12,
**dadurch gekennzeichnet, dass**
die Stromschiene (35) in Verlängerung (50) und das erste Kontaktierungselement (1) miteinander einen vorgegebenen Einbaulagewinkel (46) einschließen, der von 0° und 180° unterschiedlich ist.

14. Steckverbindungseinrichtung (2) nach einem der Ansprüche 10 bis 13,
**gekennzeichnet durch**
ein Gehäuse mit einer ersten Gehäusekammer für das erste Kontaktierungselement (1) und einer zweiten Gehäusekammer für das weitere Kontaktierungselement, wobei das Gehäuse eine Abstützeinrichtung aufweist, mittels derer die Kontaktierungselemente (1) positionsfest abgestützt sind, und wobei die Abstützeinrichtung dazu eingerichtet ist, auf die Kontaktierungselemente (1) einwirkende Positionsänderungskräfte aufzunehmen.

15. Steckverbindungseinrichtung (2) nach einem der Ansprüche 10 bis 15,
**dadurch gekennzeichnet, dass**
das Gehäuse eine Taumelstütze aufweist, die dazu eingerichtet ist, an dem Kontaktierungspin (7) befestigt zu werden, sodass der Kontaktierungspin (7) sich durch ein Überwurfelement (48) der Taumelstütze hindurcherstreckt und dadurch gegen ein Taumeln in Bezug zu dem Gehäuse gesichert ist.
